# EUROPEAN PATENT SPECIFICATION

(11) **EP 3 579 292 B1**
(45) Date of publication and mention of the grant of the patent: **05.08.2020**
(21) Application number: 18764723.5
(22) Date of filing: 08.03.2018
(51) Int. Cl.: H01L 51/54, C09K 11/06

(54) **ORGANIC LIGHT EMITTING DEVICE**
ORGANISCHE LICHTEMITTIERENDE VORRICHTUNG
DISPOSITIF ÉLECTROLUMINESCENT ORGANIQUE

(30) Priority: 09.03.2017 KR 20170030167
(43) Date of publication of application: 11.12.2019
(73) Proprietor: LG Chem, Ltd., Seoul 07336 (KR)
(72) Inventor: SUH, Sang Duk, Daejeon 34122 (KR); HONG, Sung Kil, Daejeon 34122 (KR); KIM, Seong So, Daejeon 34122 (KR)
(74) Representative: Hoffmann Eitle
(86) International application number: PCT/KR2018/002777
(87) International publication number: WO 2018/164511

(56) References cited:
- EP-A1- 2 779 263
- JP-A- 2007 138 228
- KR-A- 20130 080 872
- KR-A- 20140 083 107
- KR-A- 20150 006 722
- KR-A- 20170 064 131
- KR-B1- 101 561 479
- US-A1- 2012 056 165

## Description

### [Technical Field]

### CROSS-REFERENCE TO RELATED APPLICATION(S)

This application claims the benefit of the filing date of Korean Patent Application No. 10-2017-0030167 filed with Korean Intellectual Property Office on March 9, 2017.

The present invention relates to an organic light emitting device having improved driving voltage, efficiency and lifetime.

### [Background Art]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again. Exemplary OLED devices comprising anthracene derivative host materials in the emission layer are disclosed in Patent Literature 0002 and 0003.

In the organic light emitting device as described above, there is a continuing demand for developing an organic light emitting device having improved driving voltage, efficiency and lifetime.

### [Prior Art Literature]

### [Patent Literature]

(Patent Literature 0001) Korean Patent Laid-open Publication No. 10-2000-0051826
(Patent Literature 0002) US Patent Laid-open Publication No. 2012/0056165 A1
(Patent Literature 0003) Korean Patent Laid-open Publication No. 10-2014-0083107

### [DETAILED DESCRIPTION OF THE INVENTION]

### [Technical Problem]

It is an object of the present invention to provide an organic light emitting device having improved driving voltage, efficiency and lifetime.

### [Technical Solution]

In one aspect of the invention, there is provided an organic light emitting device including:
an anode;
a cathode;
a light emitting layer disposed between the anode and the cathode; and
a hole transport region between the anode and the light emitting layer,
wherein the light emitting layer comprises a compound represented by the following Chemical Formula 1, and
wherein the hole transport region comprises a compound represented by the following Chemical Formula 2: 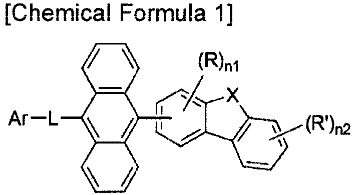 in Chemical Formula 1,
   X is O, or S,
   L is a bond; or a substituted or unsubstituted C₆₋₆₀ arylene,
   Ar is a substituted or unsubstituted C₆₋₆₀ aryl,
   R and R' are each independently hydrogen; deuterium; halogen; nitrile; nitro; amino; a substituted or unsubstituted C₁₋₆₀ alkyl; a substituted or unsubstituted C₃₋₆₀ cycloalkyl; a substituted or unsubstituted C₂₋₆₀ alkenyl group; a substituted or unsubstituted C₆₋₆₀ aryl; or a substituted or unsubstituted C₂₋₆₀ heteroaryl containing at least one heteroatom selected from the group consisting of N, O and S,
   n1 is an integer of 0 to 3, and
   n2 is an integer of 0 to 4, 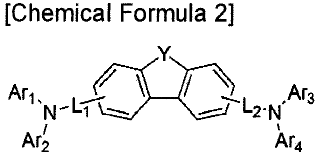
   in Chemical Formula 2,
   L₁ and L₂ are each independently a bond; or a substituted or unsubstituted C₆₋₆₀ arylene,
   Ar₁ to Ar₄ are each independently a substituted or unsubstituted C₆₋₆₀ aryl,
   Y is CR₁R₂, NR₁, O, S, or SiR₁R₂,
   R₁ and R₂ are each independently a substituted or unsubstituted C₁₋₆₀ alkyl, or -L₃-Ar₅,
   L₃ is a bond; or a substituted or unsubstituted C₆₋₆₀ arylene, and
   Ar₅ is a substituted or unsubstituted C₆₋₆₀ aryl, or a substituted or unsubstituted C₂₋₆₀ heteroaryl containing at least one heteroatom selected from the group consisting of N, O and S.

### [ADVANTAGEOUS EFFECTS]

The organic light emitting device described above is excellent in driving voltage, efficiency and lifetime.

### [BRIEF DESCRIPTION OF DRAWINGS]

FIG. 1 shows an example of an organic light emitting device comprising a substrate 1, an anode 2, a hole transport region 3, a light emitting layer 4, and a cathode 5.
FIG. 2 shows an example of an organic light emitting device comprising a substrate 1, an anode 2, a hole transport layer 6, an electron blocking layer 7, a light emitting layer 4, and a cathode 5.
FIG. 3 shows an example of an organic light emitting device comprising a substrate 1, an anode 2, a hole transport layer 6, an electron blocking layer 7, a light emitting layer 4, an electron transport layer 8, and a cathode 5.

### [DETAILED DESCRIPTION OF THE EMBODIMENTS]

Hereinafter, the present invention will be described in more detail to help understanding of the present invention.

As used herein, the notation 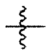 means a bond linked to another substituent group.

As used herein, the term "substituted or unsubstituted" means being unsubstituted or substituted with one or more substituents selected from the group consisting of deuterium; a halogen group; a nitrile group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and a heterocyclic group containing at least one of N, O and S atoms, or being unsubstituted or substituted with a substituent to which two or more substituents are linked among the substituents exemplified above. For example, "the substituent to which two or more substituents are linked" may be a biphenyl group. That is, the biphenyl group may also be an aryl group, and may be interpreted as a substituent to which two phenyl groups are linked.

In the present specification, the number of carbon atoms of a carbonyl group is not particularly limited, but is preferably 1 to 40. Specifically, the carbonyl group may be a compound having the following structural formulae, but is not limited thereto.

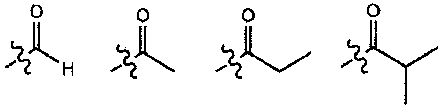

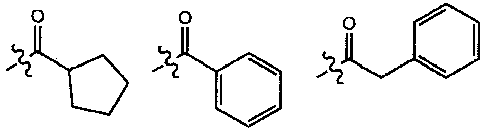

In the present specification, for an ester group, the oxygen of the ester group may be substituted with a straight-chain, branched-chain, or cyclic alkyl group having 1 to 25 carbon atoms, or an aryl group having 6 to 25 carbon atoms. Specifically, the ester group may be a compound having the following structural formulae, but is not limited thereto.

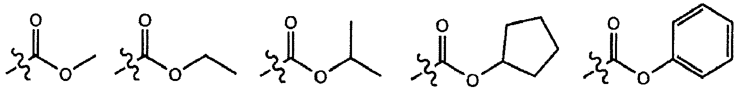

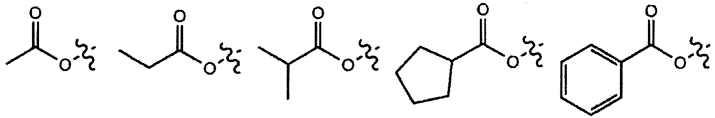

In the present specification, the number of carbon atoms of an imide group is not particularly limited, but is preferably 1 to 25. Specifically, the imide group may be a compound having the following structural formulae, but is not limited thereto.

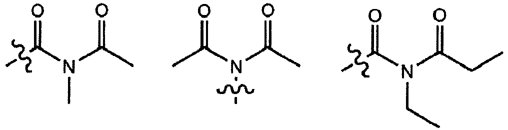

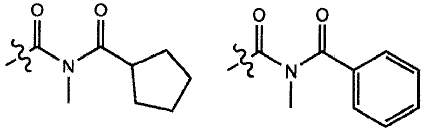

In the present specification, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but is not limited thereto.

In the present specification, a boron group specifically includes a trimethylboron group, a triethylboron group, a t-butyldimethylboron group, a triphenylboron group, and a phenylboron group, but is not limited thereto.

In the present specification, examples of a halogen group include fluorine, chlorine, bromine, or iodine.

In the present specification, the alkyl group may be a straight chain or branched chain, and the number of carbon atoms thereof is not particularly limited, but is preferably 1 to 40. According to one embodiment, the number of carbon atoms of the alkyl group is 1 to 20. According to another embodiment, the number of carbon atoms of the alkyl group is 1 to 10. According to another embodiment, the number of carbon atoms of the alkyl group is 1 to 6. Specific examples of the alkyl group include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cycloheptylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethyl-propyl, isohexyl, 2-methylpentyl, 4-methylhexyl, 5-methylhexyl, and the like, but are not limited thereto.

In the present specification, the alkenyl group may be a straight chain or branched chain, and the number of carbon atoms thereof is not particularly limited, but is preferably 2 to 40. According to one embodiment, the number of carbon atoms of the alkenyl group is 2 to 20. According to another embodiment, the number of carbon atoms of the alkenyl group is 2 to 10. According to still another embodiment, the number of carbon atoms of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present specification, a cycloalkyl group is not particularly limited, but the number of carbon atoms thereof is preferably 3 to 60. According to one embodiment, the number of carbon atoms of the cycloalkyl group is 3 to 30. According to another embodiment, the number of carbon atoms of the cycloalkyl group is 3 to 20. According to still another embodiment, the number of carbon atoms of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present specification, an aryl group is not particularly limited, but preferably has 6 to 60 carbon atoms, and may be a monocyclic aryl group or a polycyclic aryl group. According to one embodiment, the number of carbon atoms of the aryl group is 6 to 30. According to one embodiment, the number of carbon atoms of the aryl group is 6 to 20. The aryl group may be a phenyl group, a biphenyl group, a terphenyl group or the like as the monocyclic aryl group, but is not limited thereto. Examples of the polycyclic aryl group include a naphthyl group, an anthracenyl group, a phenanthryl group, a pyrenyl group, a perylenyl group, a chrysenyl group and a fluorenyl group or the like, but is not limited thereto.

In the present specification, a fluorenyl group may be substituted, and two substituent groups may be bonded to each other to form a spiro structure. In the case where the fluorenyl group is substituted, 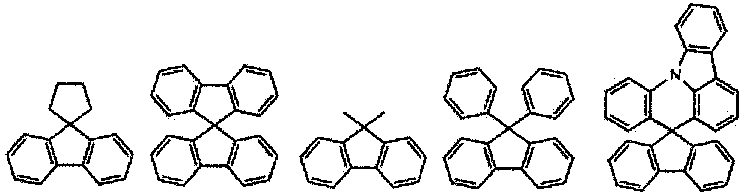 and the like can be formed. However, the structure is not limited thereto.

In the present specification, a heterocyclic group is a heterocyclic group including one or more of O, N, Si and S as a heteroatom, and the number of carbon atoms thereof is not particularly limited, but is preferably 2 to 60. Examples of the heterocyclic group include a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present specification, the aryl group in the aralkyl group, the aralkenyl group, the alkylaryl group, and the arylamine group is the same as the aforementioned examples of the aryl group. In the present specification, the alkyl group in the aralkyl group, the alkylaryl group and the alkylamine group is the same as the aforementioned examples of the alkyl group. In the present specification, the heteroaryl in the heteroarylamine can be applied to the aforementioned description of the heterocyclic group. In the present specification, the alkenyl group in the aralkenyl group is the same as the aforementioned examples of the alkenyl group. In the present specification, the aforementioned description of the aryl group may be applied except that the arylene is a divalent group. In the present specification, the aforementioned description of the heterocyclic group can be applied except that the heteroarylene is a divalent group. In the present specification, the aforementioned description of the aryl group or cycloalkyl group can be applied except that the hydrocarbon ring is not a monovalent group but formed by combining two substituent groups. In the present specification, the aforementioned description of the heterocyclic group can be applied, except that the heterocycle is not a monovalent group but formed by combining two substituent groups.

Hereinafter, the present invention will be described in detail for each configuration.

### Anode and Cathode

The anode and cathode used in the present invention mean electrodes used in an organic light emitting device.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:AI or SNO₂:Sb; conductive polymers such as poly(3-methylthiophene), poly[3,4-(ethylene-1,2-dioxy)thiophene](PEDOT), polypyrrole, and polyaniline, and the like, but are not limited thereto.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/AI or LiO₂/Al, and the like, but are not limited thereto.

### Hole injection layer

The organic light emitting device according to the present invention may further comprise a hole injection layer between the anode and a hole transport region described below.

The hole injection layer is a layer injecting holes from an electrode, and the hole injection material is preferably a compound which has an ability of transporting the holes, a hole injection effect in the anode and an excellent hole injection effect to the light emitting layer or the light emitting material, prevents movement of an exciton generated in the light emitting layer to the electron injection layer or the electron injection material, and has an excellent thin film forming ability. It is preferable that a HOMO (highest occupied molecular orbital) of the hole injection material is between the work function of the anode material and a HOMO of a peripheral organic material layer.

Specific examples of the hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer, and the like, but are not limited thereto.

### Hole Transport Region

The hole transport layer used in the present invention is a region that receives holes from an anode or a hole injection layer formed on the anode and transports the holes to the light emitting layer.

The hole transport region comprises a hole transport layer, or comprises a hole transport layer and an electron blocking layer. When the hole transport region comprises a hole transport layer and an electron blocking layer, preferably, the light emitting layer and the electron blocking layer are positioned adjacent to each other.

The material used in the hole transport region is suitably a material having large mobility to the holes. In particular, in the present invention, the compound represented by Chemical Formula 2 is used as a hole transport material. Accordingly, the hole transport region comprises a hole transport layer, the hole transport layer comprises the compound represented by Chemical Formula 2, or the hole transport region comprises a hole transport layer and an electron blocking layer, and the electron blocking layer comprises the compound represented by Chemical Formula 2.

In Chemical Formula 2, preferably, L₁ and L₂ are each independently a bond, or phenylene.

Preferably, Ar₁ to Ar₄ are each independently phenyl, biphenylyl, or terphenylyl.

Preferably, R₁ and R₂ are each independently methyl, phenyl, naphthyl, benzofuranyl, phenanthrenyl, naphthylphenyl, or benzofuranylphenyl.

Representative examples of the compound represented by Chemical Formula 2 are as follows:

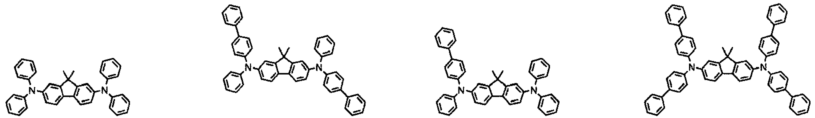

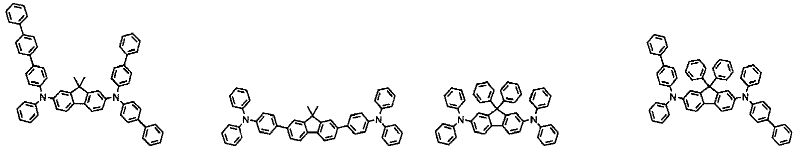

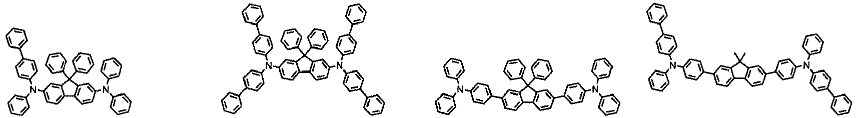

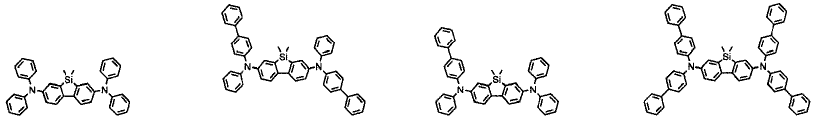

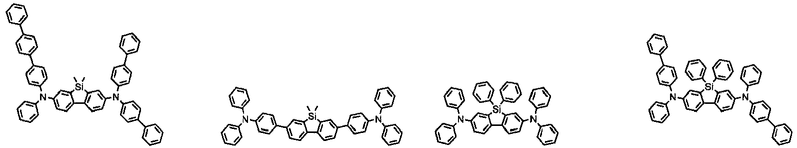

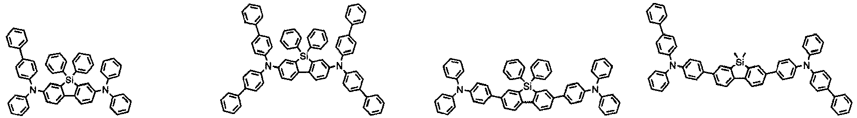

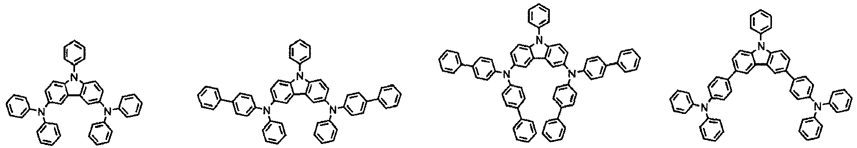

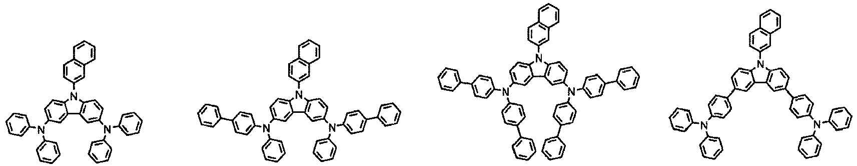

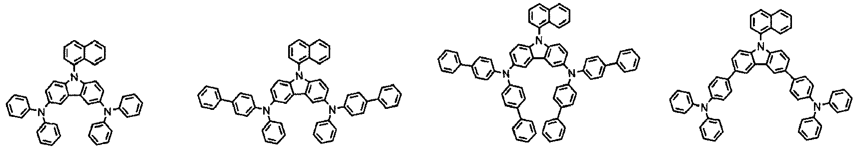

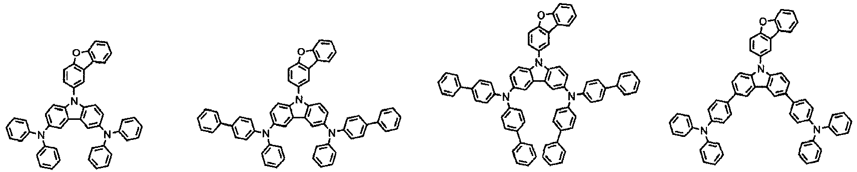

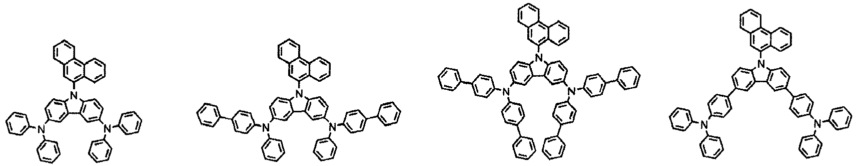

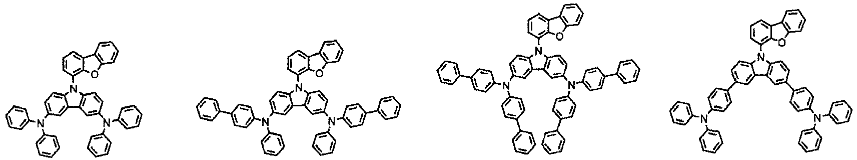

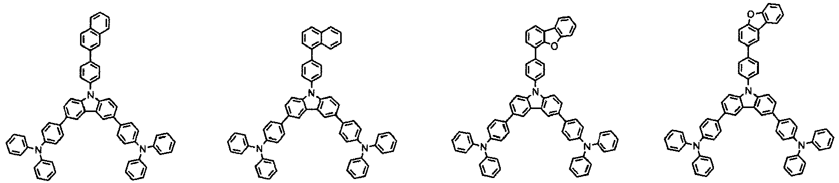

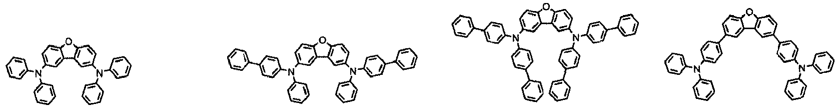

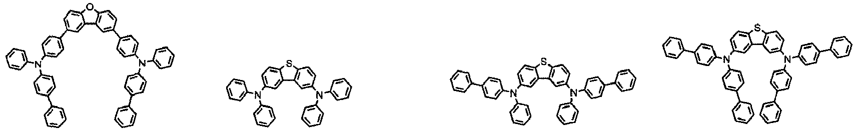

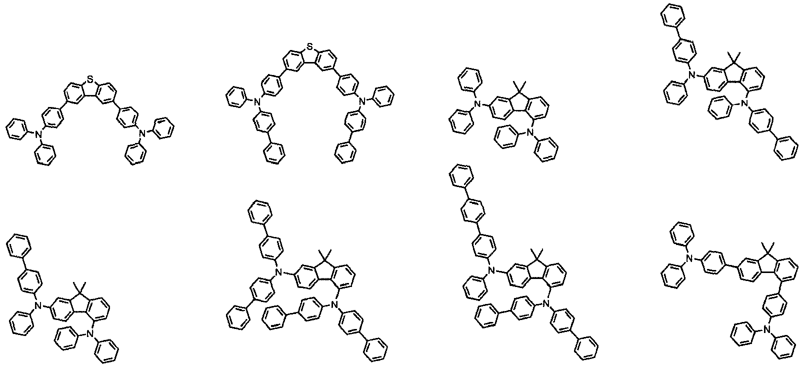

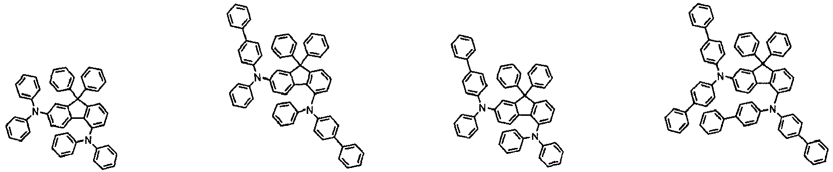

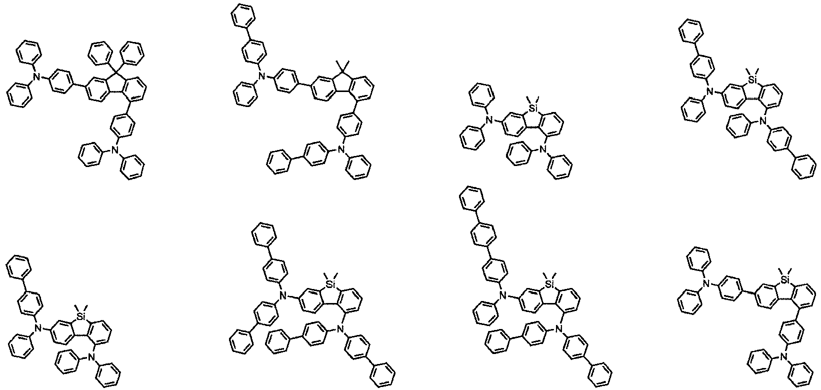

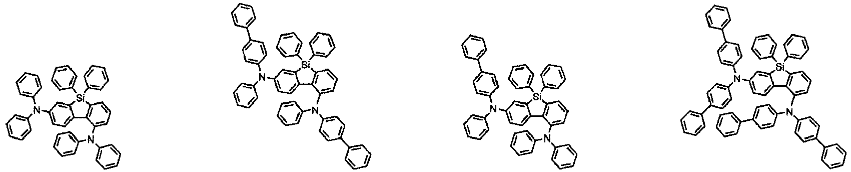

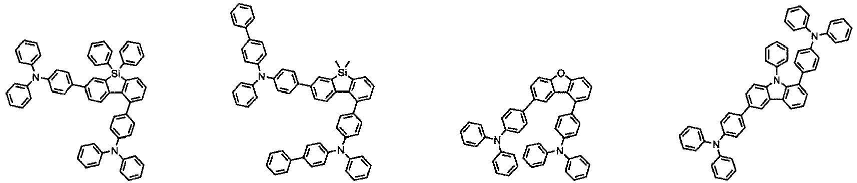

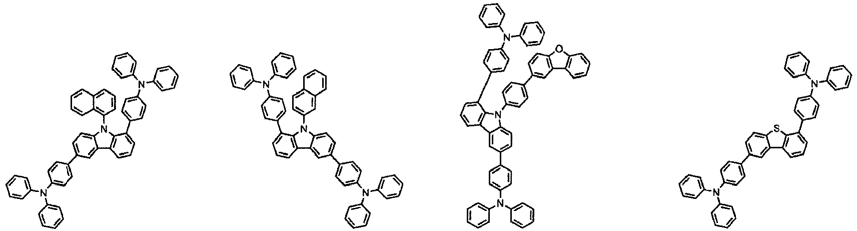

The compound represented by Chemical Formula 2 can be prepared by a method as shown in the following Reaction Scheme 2.

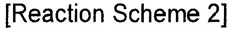

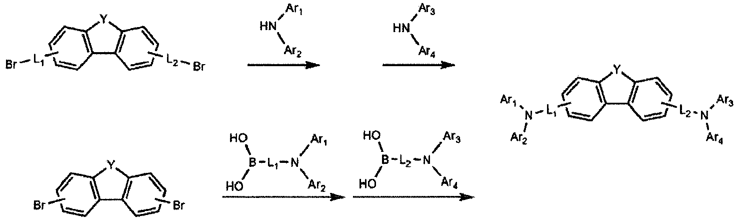

The above reaction utilizes a Suzuki coupling reaction or an amine substitution reaction, which can be further specified in Examples to be described later.

### Light Emitting Layer

The light emitting layer used in the present invention is a layer that can emit light in the visible light region by combining holes and electrons transported from the anode and the cathode, and is preferably a material having good quantum efficiency for fluorescence or phosphorescence.

Generally, the light emitting layer comprises a host material and a dopant material, and the present invention comprises the compound represented by the Chemical Formula 1 as a host
In the Chemical Formula 1, preferably, L is a bond, phenylene, biphenylylene, naphthylene, or anthracenylene.

Preferably, Ar is phenyl, biphenylyl, terphenylyl, naphthyl, phenylnaphthyl, naphthylphenyl, or phenanthrenyl.

Preferably, R and R' are each independently hydrogen, deuterium, phenyl, biphenylyl, or naphthyl.

Representative examples of the compound represented by the Chemical Formula 1 are as follows:

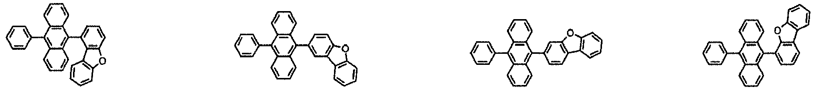

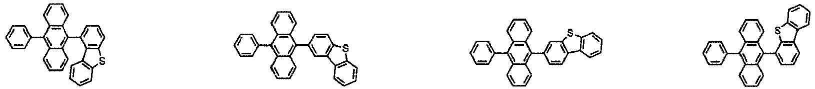

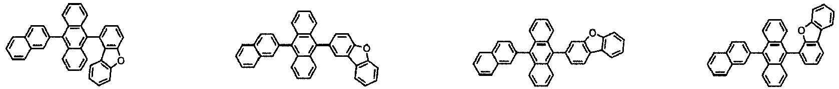

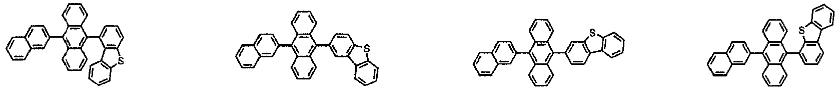

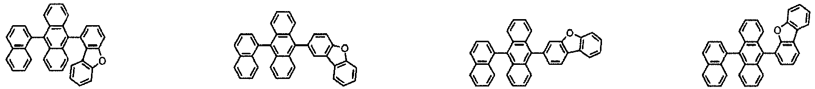

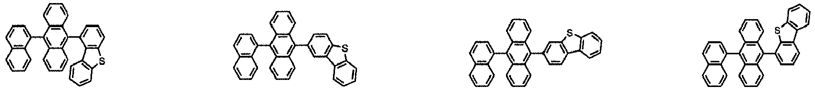

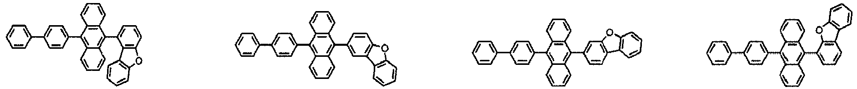

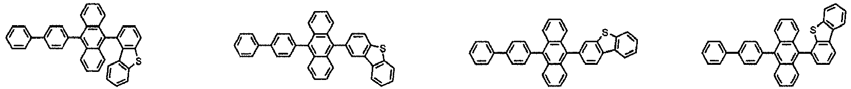

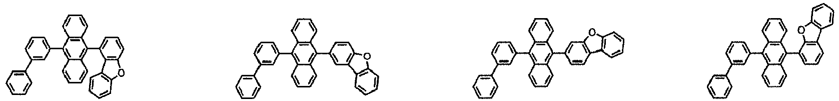

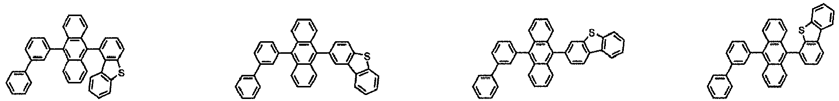

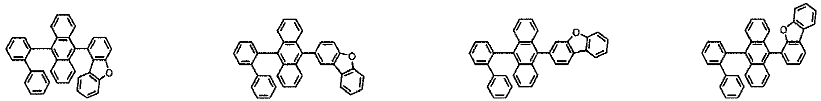

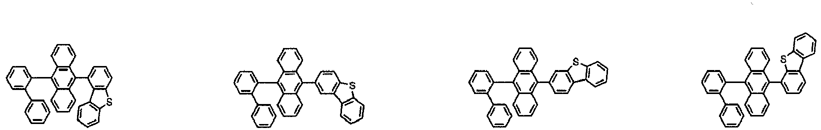

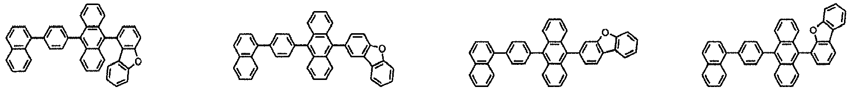

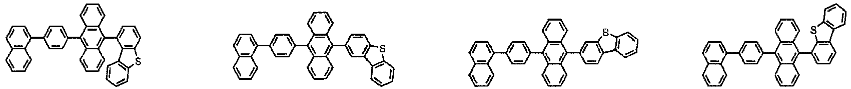

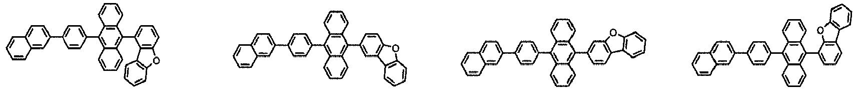

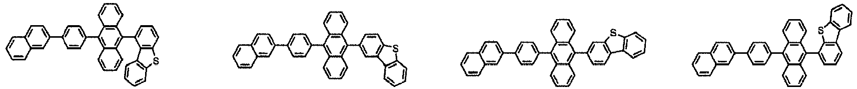

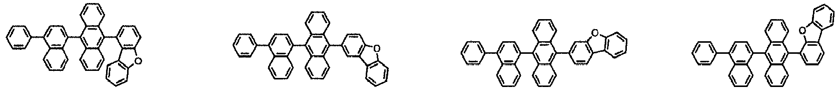

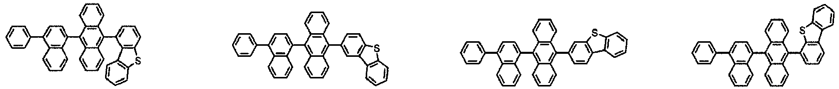

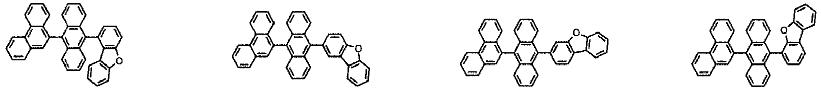

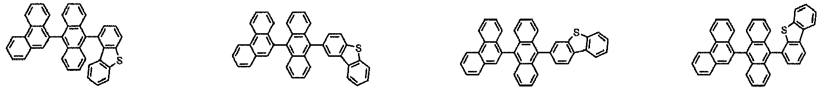

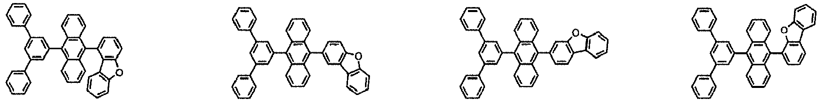

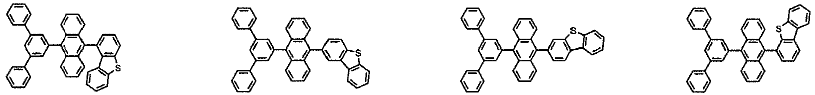

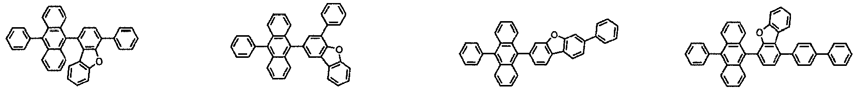

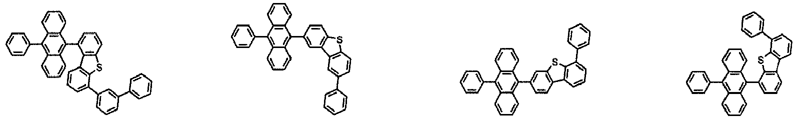

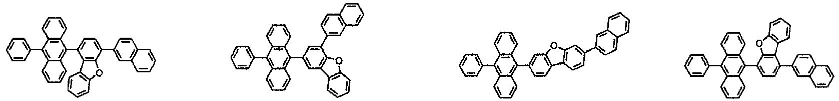

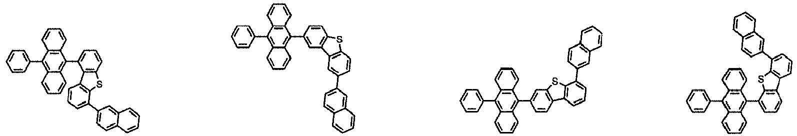

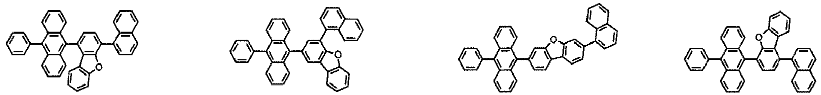

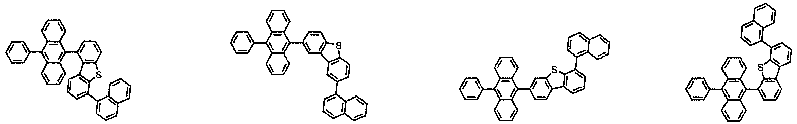

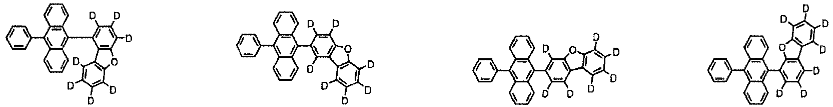

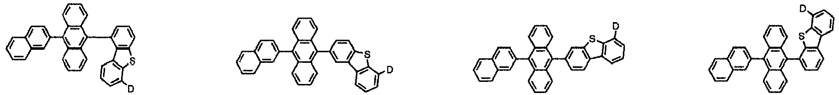

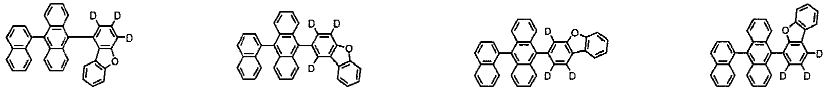

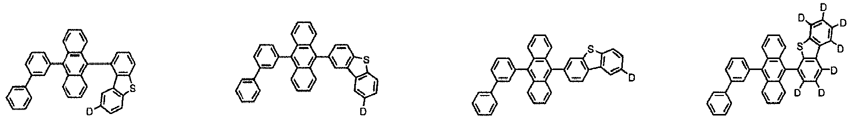

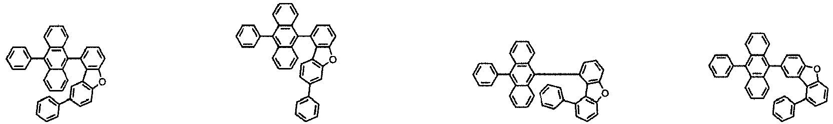

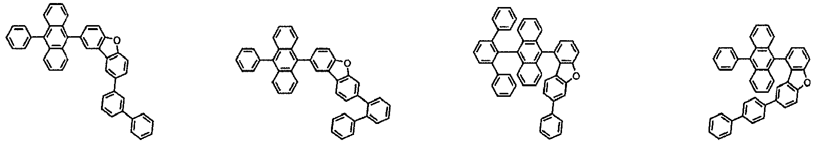

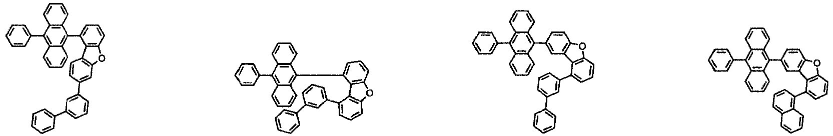

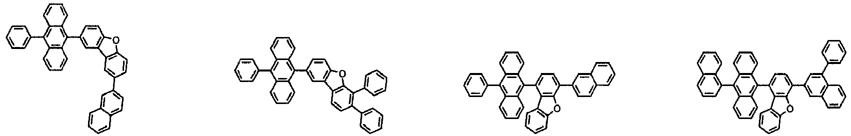

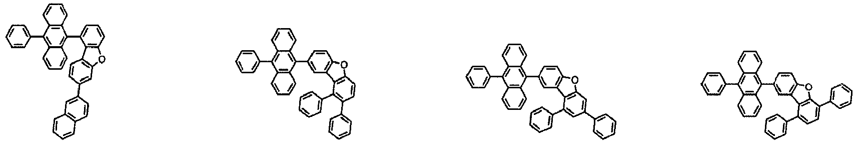

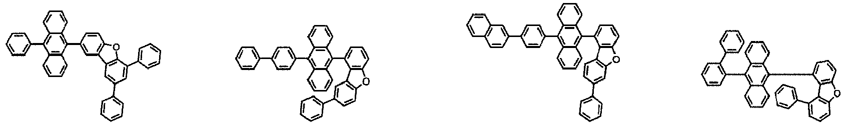

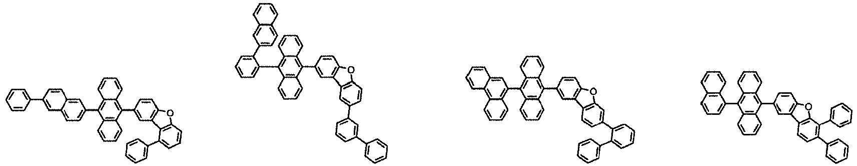

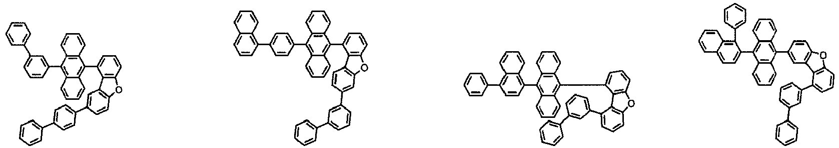

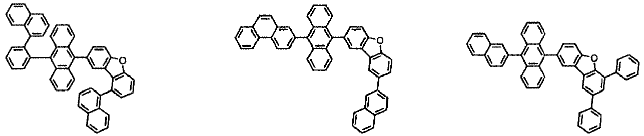

The compound represented by Chemical Formula 1 can be prepared by a method as shown in the following Reaction Scheme 1.

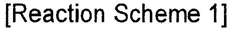

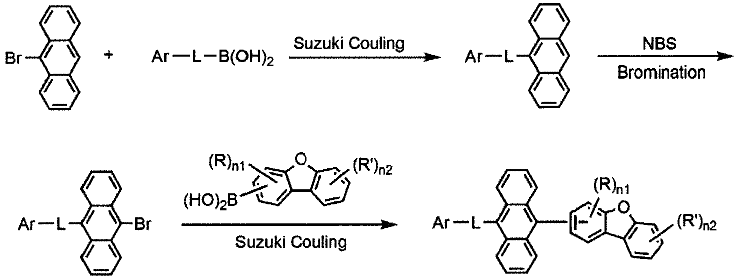

The above reaction utilizes a Suzuki coupling reaction and can be further specified in Examples to be described later.

The dopant material is not particularly limited as long as it is a material used for the organic light emitting device. As an example, an aromatic amine derivative, a styrylamine compound, a boron complex, a fluoranthene compound, a metal complex, and the like can be mentioned. Specific examples of the aromatic amine derivatives include substituted or unsubstituted fused aromatic ring derivatives having an arylamino group, examples thereof include pyrene, anthracene, chrysene, and periflanthene having the arylamino group, and the like. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto.

### Electron transport region

The organic light emitting device according to the present invention may comprise an electron transport layer between the light emitting layer and the cathode.

The electron transport layer is a layer that receives the electrons from the electron injection layer formed on the cathode and anode and transports the electrons to the light emitting layer, and that suppress the transfer of holes from the light emitting layer, and an electron transport material is suitably a material which may receive electrons well from a cathode and transfer the electrons to a light emitting layer, and has a large mobility for electrons.

Specific examples of the electron transport material include: an Al complex of 8-hydroxyquinoline; a complex including Alq₃; an organic radical compound; a hydroxyflavone-metal complex, and the like, but are not limited thereto. The electron transport layer may be used with any desired cathode material, as used according to a conventional technique. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

### Electron Injection Layer

The organic light emitting device according to the present invention may further comprise an electron injection layer between the electron transport layer and the anode. The electron injection layer is a layer which injects electrons from an electrode, and is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film.

Specific examples of the electron injection layer include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, a metal complex compound, a nitrogen-containing 5-membered ring derivative, and the like, but are not limited thereto.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium, and the like, but are not limited thereto.

### Organic light emitting device

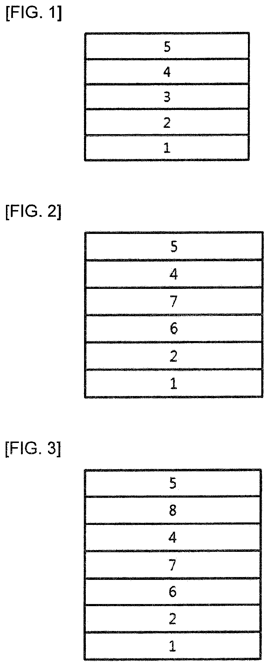

The structure of the organic light emitting device according to the present invention is illustrated in FIG. 1. FIG. 1 shows an example of an organic light emitting device comprising a substrate 1, an anode 2, a hole transport region 3, a light emitting layer 4, and a cathode 5. Also, FIG. 2 shows an example of an organic light emitting device comprising a substrate 1, an anode 2, a hole transport layer 6, an electron blocking layer 7, a light emitting layer 4, and a cathode 5. In addition, FIG. 3 shows an example of an organic light emitting device comprising a substrate 1, an anode 2, a hole transport layer 6, an electron blocking layer 7, a light emitting layer 4, an electron transport layer 8, and a cathode 5.

The organic light emitting device according to the present invention can be manufactured by sequentially stacking the above-described structures. In this case, the organic light emitting device may be manufactured by depositing a metal, metal oxides having conductivity, or an alloy thereof on the substrate by using a PVD (physical vapor deposition) method such as a sputtering method or an e-beam evaporation method to form the anode, forming the respective layers described above thereon, and then depositing a material that can be used as the cathode thereon. In addition to such a method, the organic light emitting device may be manufactured by sequentially depositing a cathode material, an organic material layer and an anode material on a substrate. Further, the light emitting layer may be formed by subjecting hosts and dopants to a vacuum deposition method and a solution coating method. Herein, the solution coating method means a spin coating, a dip coating, a doctor blading, an inkjet printing, a screen printing, a spray method, a roll coating, or the like, but is not limited thereto.

In addition to such a method, the organic light emitting device may be manufactured by sequentially depositing a cathode material, an organic material layer, and an anode material on a substrate (International Publication WO 2003/012890). However, the manufacturing method is not limited thereto.

On the other hand, the organic light emitting device according to the present invention may be a front side emission type, a back side emission type, or a double side emission type according to the used material.

Hereinafter, preferred examples will be presented to facilitate understanding of the present invention. However, these examples are provided for a better understanding of the present invention only, and are not intended to limit the scope of the present invention.

### [Preparation Example]

### Preparation Example 1-1: Preparation of Compound 1-1

### Step 1) Preparation of Compound 1-1-a

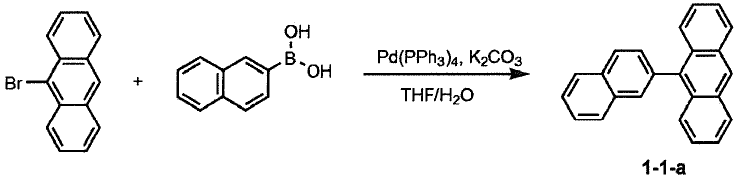

To a three-necked flask was added a solution where 9-bromoanthracene (20.0 g, 77.8 mmol) and naphthalene-2-ylboronic acid (14.7 g, 85.6 mmol) were dissolved in THF (300 mL) and K₂CO₃ (43.0 g, 311.1 mmol) was dissolved in water (150 mL). Pd(PPh₃)₄ (3.6 g, 3.1 mmol) was added thereto, and the reaction mixture was stirred at reflux under an argon atmosphere for 8 hour. After the reaction was completed, the reaction solution was cooled to room temperature, then transferred to a separatory funnel, and extracted with water and ethyl acetate. The extract was dried over MgSO₄, filtered, and concentrated. The sample was purified by silica gel column chromatography to obtain Compound 1-1-a (18.5 g, yield 78%, MS: [M+H]⁺ = 304).

### Step 2) Preparation of Compound 1-1-b

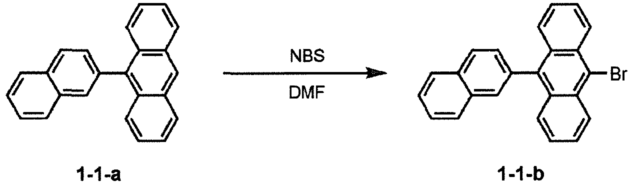

Compound 1-1-a (15.0 g, 49.3 mmol), NBS (9.2 g, 51.7 mmol) and DMF (300 mL) were added to a two-necked flask, and the mixture was stirred at room temperature under an argon atmosphere for 8 hour. After the reaction was completed, the reaction solution was transferred to a separatory funnel, and the organic layer was extracted with water and ethyl acetate. The extract was dried over MgSO₄, filtered, and concentrated. The sample was then purified by silica gel column chromatography to obtain Compound 1-1-b (16.6 g, yield 88%, MS: [M+H]⁺ = 383).

### Step 3) Preparation of Compound 1-1

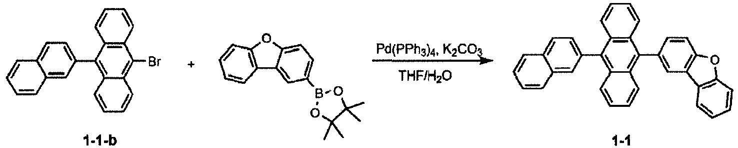

To a three-necked flask was added a solution where Compound 1-1-b (15.0 g, 39.1 mmol), 2-(dibenzo[b,d]furan-2-yl)-4,4,5,5-tetramethyl-1,3,2-dioxaborolane (12.7 g, 43.0 mmol) were dissolved in THF (225 mL) and K₂CO₃ (21.6 g, 156.5 mmol) was dissolved in water (113 mL). Pd(PPh₃)₄ (1.8 g, 1.6 mmol) was added thereto, and the reaction mixture was stirred at reflux under an argon atmosphere for 8 hours. After the reaction was completed, the reaction solution was cooled to room temperature, then transferred to a separatory funnel, and extracted with water and ethyl acetate. The extract was dried over MgSO₄, filtered, and concentrated. The sample was purified by silica gel column chromatography and then purified by sublimation to obtain Compound 1-1 (6.4 g, yield 35%, MS: [M+H]⁺ = 471).

### Preparation Example 1-2: Preparation of Compound 1-2

### Step 1) Preparation of Compound 1-2-a

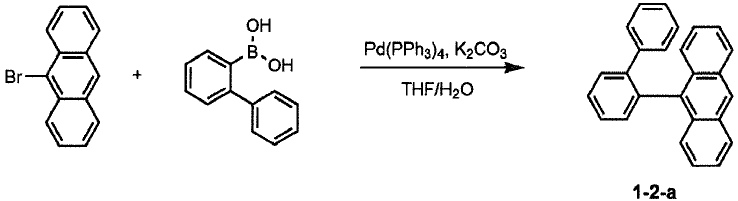

Compound 1-2-a (19.3 g, yield 75%, MS: [M+H]⁺= 330) was prepared in the same manner as in the preparation method of Compound 1-1-a, except that [1,1'-biphenyl]-2-ylboronic acid was used instead of naphthalene-2-ylboronic acid in Step 1 of Preparation Example 1-1.

### Step 2) Preparation of Compound 1-2-b

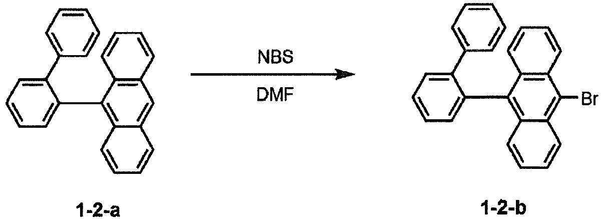

Compound 1-2-b (16.9 g, yield 91%, MS: [M+H]⁺= 409) was prepared in the same manner as in the preparation method of Compound 1-1-b, except that Compound 1-2-a was used instead of Compound 1-1-a in Step 2 of Preparation Example 1-1.

### Step 3) Preparation of Compound 1-2

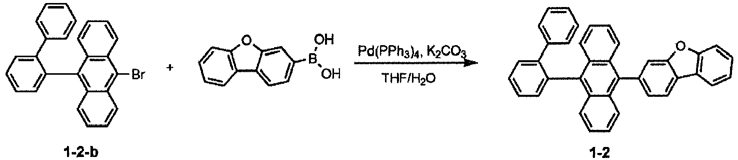

Compound 1-2 (5.8 g, yield 32%, MS: [M+H]⁺= 497) was prepared in the same manner as in the preparation method of Compound 1-1, except that Compound 1-2-b was used instead of Compound 1-1-b and dibenzo[b,d]furan-3-ylboronic acid was used instead of 2-(dibenzo[b,d] furan-2-yl)-4,4,5,5-tetramethyl-1,3,2-dioxaborolane, in Step 3 of Preparation Example 1-1.

### Preparation Example 1-3: Preparation of Compound 1-3

### Step 1) Preparation of Compound 1-3-a

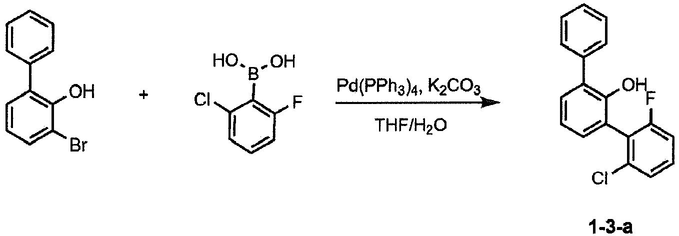

To a three-necked flask was added a solution where 3-bromo-[1,1'-biphenyl]-2-ol (30.0 g, 120.4 mmol) and (2-chloro-6-fluorophenyl)boronic acid (23.1 g, 132.5 mmol) were dissolved in THF (450 mL) and K₂CO₃ (66.6 g, 481.7 mmol) was dissolved in water (225 mL). Pd(PPh₃)₄ (5.6 g, 4.8 mmol) was added thereto, and the mixture was stirred at reflux under argon atmosphere for 8 hours. After the reaction was completed, the reaction solution was cooled to room temperature, transferred to a separatory funnel and then extracted with water and ethyl acetate. The extract was dried over MgSO₄, filtered, and concentrated. The sample was then purified by silica gel column chromatography to obtain Compound 1-3-a (27.0 g, yield 75%, MS: [M+H]+=299).

### Step 2) Preparation of Compound 1-3-b

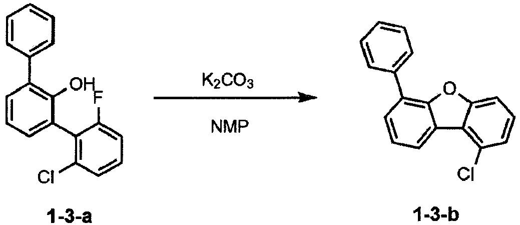

Compound 1-3-a (25.0 g, 83.7 mmol), K₂CO₃ (23.1 g, 167.4 mmol) and NMP (325 mL) were added to a three-necked flask, and the mixture was stirred at 120°C overnight. After the reaction was completed, the reaction solution was cooled to room temperature, and water (300 mL) was added dropwise thereto little by little. Then, the reaction solution was transferred to a separatory funnel, and the organic layer was extracted with water and ethyl acetate. The extract was dried over MgSO₄, filtered, and concentrated. The sample was then purified by silica gel column chromatography to obtain Compound 1-3-b (19.8 g, yield 85%, MS: [M+H]⁺=279).

### Step 3) Preparation of Compound 1-3-c

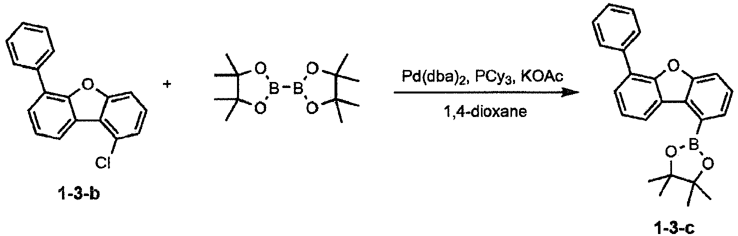

Compound 1-3-b (18.0 g, 64.6 mmol), bis(pinacolato)diboron (19.7 g, 77.5 mmol), Pd(dba)₂ (0.7 g, 1.3 mmol), tricyclohexyl phosphine (0.7 g, 2.6 mmol), KOAc (12.7 g, 129.2 mmol), and 1,4-dioxane (270 mL) were added to a three-necked flask and the mixture was stirred a reflux under argon atmosphere for 12 hours. After the reaction was completed, the reaction solution was cooled to room temperature and then transferred to a separatory funnel, to which water (200 mL) was added, and extracted with ethyl acetate. The extract was dried over MgSO₄, filtered, and concentrated. The sample was then purified by silica gel column chromatography to obtain Compound 1-3-c (20.5 g, yield 73%, MS: [M+H]⁺=370)

### Step 4) Preparation of Compound 1-3-d

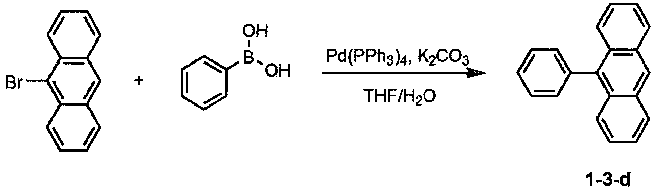

Compound 1-3-d (15.6 g, yield 79%, MS: [M+H]⁺= 254) was prepared in the same manner as in the preparation method of Compound 1-1-a, except that phenylboronic acid was used instead of naphthalene-2-ylboronic acid in Step 1 of Preparation Example 1-1.

### Step 5) Preparation of Compound 1-3-e

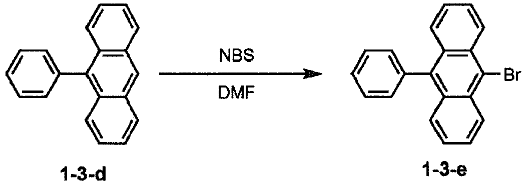

Compound 1-3-e (17.3 g, yield 88%, MS: [M+H]⁺= 333) was prepared in the same manner as in the preparation method of Compound 1-1-b, except that Compound 1-3-d was used instead of Compound 1-1-a in Step 2 of Preparation Example 1-1.

### Step 6) Preparation of Compound 1-3

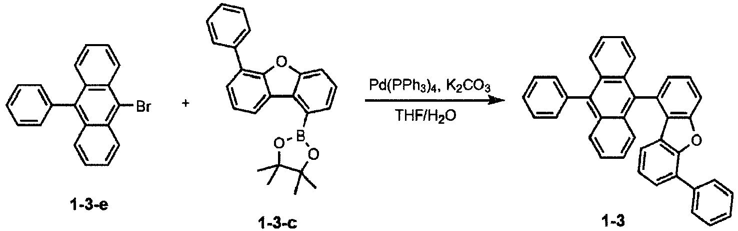

Compound 1-3 (7.4 g, yield 32%, MS: [M+H]⁺= 497) was prepared in the same manner as in the preparation method of Compound 1-1, except that Compound 1-3-e was used instead of Compound 1-1-b and Compound 1-3-c was used instead of 2-(dibenzo[b,d]furan-2-yl)-4,4,5,5-tetramethyl-1,3,2-dioxaborolane in Step 3 of Preparation Example 1-1.

### Preparation Example 1-4: Preparation of Compound 1-4

### Step 1) Preparation of Compound 1-4-a

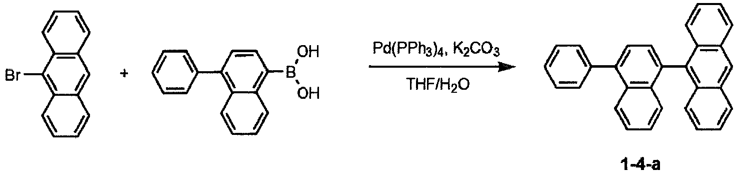

Compound 1-4-a (20.1 g, yield 68%, MS: [M+H]⁺= 380) was prepared in the same manner as in the preparation method of Compound 1-1-a, except that (4-phenylnaphthalen-1-yl)boronic acid was used instead of naphthalene-2-yl boronic acid in Step 1 of Preparation Example 1-1.

### Step 2) Preparation of Compound 1-4-b

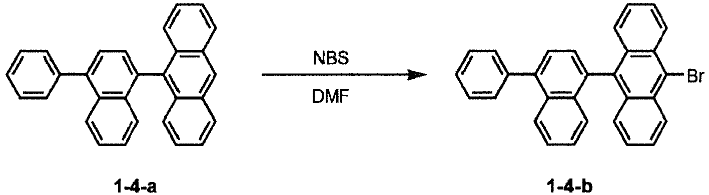

Compound 1-4-b (15.4 g, yield 85%, MS: [M+H]⁺= 459) was prepared in the same manner as in the preparation method of Compound 1-1-b, except that Compound 1-4-a was used instead of Compound 1-1-a in Step 2 of Preparation Example 1-1.

### Step 3) Preparation of Compound 1-4

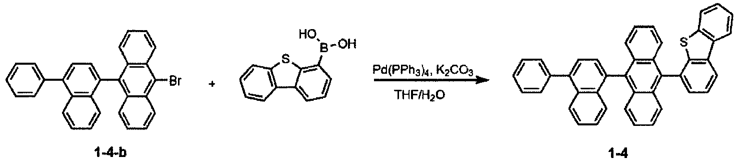

Compound 1-4 (5.1 g, yield 28%, MS: [M+H]⁺= 563) was prepared in the same manner as in the preparation method of Compound 1-1, except that Compound 1-4-b was used instead of Compound 1-1-b and dibenzo[b,d]thiophen-4-ylboronic acid was used instead of 2-(dibenzo[b,d]furan-2-yl)-4,4,5,5-tetramethyl-1,3,2-dioxaborolane in Step 3 of Preparation Example 1-1.

### Preparation Example 2-1: Preparation of Compound 2-1

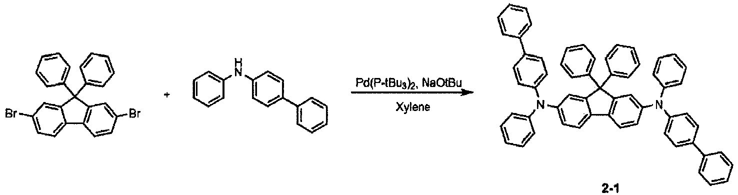

In a three-necked flask, 2,7-dibromo-9,9-dimethyl-9H-fluorene (20.0 g, 44.3 mmol) and N-phenyl-[1,1'-biphenyl]-4-amine (30.7 g, 125.0 mmol) were dissolved in xylene (500 mL), and then sodium tert-butoxide (16.4 g, 170.4 mmol) and Pd(P(t-Bu)₃)₂ (0.3 g, 0.6 mmol) were added thereto. The mixture was stirred at reflux under argon atmosphere for 12 hours. After the reaction was completed, the mixture was cooled to room temperature, and water (300 mL) was added thereto, and the reaction solution was transferred to a separatory funnel, and extracted. The extract was dried over MgSO₄, filtered, and concentrated. The sample was purified by silica gel column chromatography and then purified by sublimation to obtain Compound 2-1 (8.1 g, yield 24%, MS: [M+H]⁺=681).

### Preparation Example 2-2: Preparation of Compound 2-2

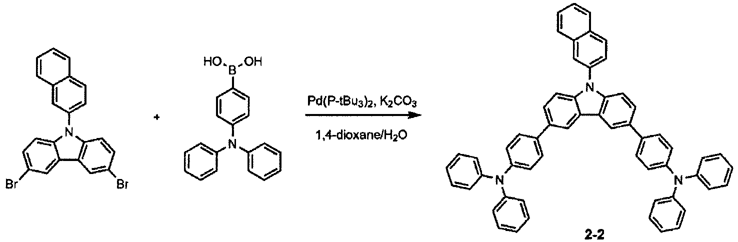

To a three-necked flask was added a solution where 3,6-dibromo-9-(naphthalen-2-yl)-9H-carbazole (20.0 g, 44.3 mmol) and 4-(diphenylamino)phenyl)boronic acid (28.2 g, 97.5 mmol) were dissolved in 1,4-dioxane (400 mL) and K₂CO₃ (36.8 g, 266.0 mmol) was dissolved in water (200 mL). Pd(P(t-Bu)₃)₂ (0.2 g, 0.4 mmol) was added thereto, and the mixture was stirred at reflux under an argon atmosphere for 12 hours. After the reaction was completed, the reaction solution was cooled to room temperature, then transferred to a separatory funnel and extracted with water and ethyl acetate. The extract was dried over MgSO₄, filtered, and concentrated. The sample was purified by silica gel column chromatography and then purified by sublimation to obtain Compound 2-2 (7.3 g, yield 21%, MS: [M+H]⁺=780).

### Preparation Example 2-3: Preparation of Compound 2-3

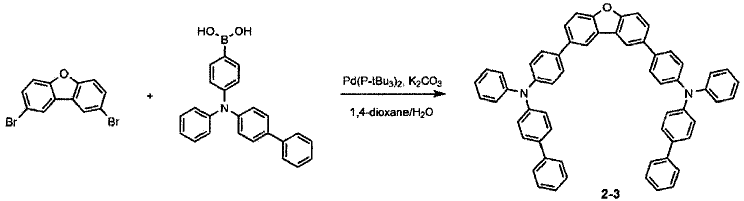

Compound 2-3 (13.9 g, yield 28%, MS: [M+H]⁺= 807) was prepared in the same manner as in the preparation method of Compound 2-2, except that 2,8-dibromodibenzo[b,d]furan was used instead of 3,6-dibromo-9-(naphthalen-2-yl)-9H-carbazole and (4-([1,1'-biphenyl]-4-yl(phenyl)amino)phenyl)boronic acid was used instead of 4-(diphenylamino)phenyl)boronic acid in Preparation Example 2-2.

### Preparation Example 2-4: Preparation of Compound 2-4

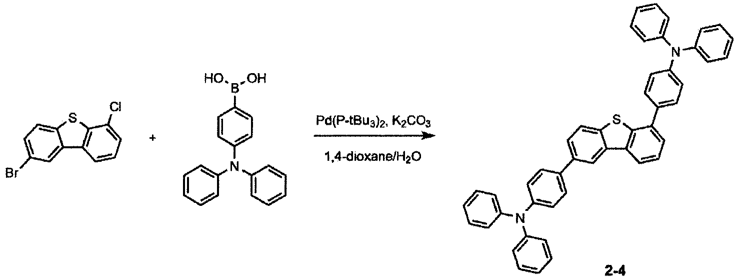

Compound 2-4 (14.0 g, yield 31%, MS: [M+H]⁺= 671) was prepared in the same manner as in the preparation method of Compound 2-2, except that 2-bromo-6-chlorodibenzo[b,d]thiophene was used instead of 3,6-dibromo-9-(naphthalen-2-yl)-9H-carbazole in Preparation Example 2-2.

### [Example 1]

### Example 1-1

A glass substrate on which ITO (indium tin oxide) was coated as a thin film to a thickness of 1,400 A was put into distilled water in which a detergent was dissolved, and ultrasonically cleaned. In this case, a product manufactured by Fischer Co., was used as the detergent, and as the distilled water, distilled water filtered twice using a filter manufactured by Millipore Co., was used. After the ITO was cleaned for 30 minutes, ultrasonic cleaning was repeated twice using distilled water for 10 minutes. After the cleaning with distilled water was completed, the substrate was ultrasonically cleaned with solvents of isopropyl alcohol, acetone, and methanol, then dried, and then transferred to a plasma cleaner. In addition, the substrate was cleaned for 5 minutes using oxygen plasma, and then transferred to a vacuum depositor.

On the ITO transparent electrode thus prepared, a compound represented by Formula HI-A below and a compound represented by Formula HAT below were sequentially subjected to thermal vacuum-deposition in a thickness of 650 Å and 50 Å, respectively, to form a hole injection layer. Compound 2-1 prepared in the previous Preparation Example 2-1 was vacuum-deposited thereon in a thickness of 600 Å as a hole transport layer, and then a compound represented by Formula EB-1 below was thermally vacuum-deposited in a thickness of 50 Å as an electron blocking layer. Then, the Compound 1-1 prepared in the previous Preparation Example 1-1 and a compound represented by Formula BD below were vacuum-deposited at a weight ratio of 96: 4 as a light emitting layer in a thickness of 200 Å. Then, a compound represented by Formula ET-A below and a compound represented by Formula Liq below were thermally vacuum-deposited at a weight ratio of 1:1 in a thickness of 360 Å as an electron transport layer and an electron injection layer, and then the compound represented by Formula Liq below was vacuum-deposited in a thickness of 5 Å. Magnesium and silver were sequentially deposited at a weight ratio of 10: 1 on the electron injection layer in a thickness of 220 Å, and aluminum was deposited in a thickness of 1000 Å to form a cathode, thereby manufacturing an organic light emitting device.

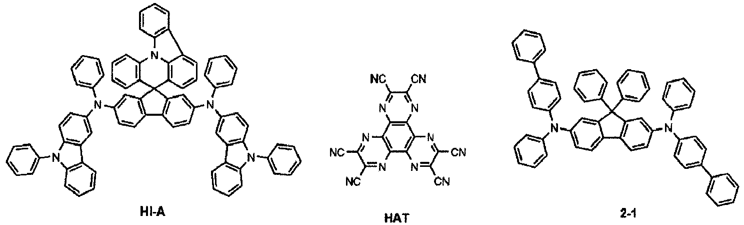

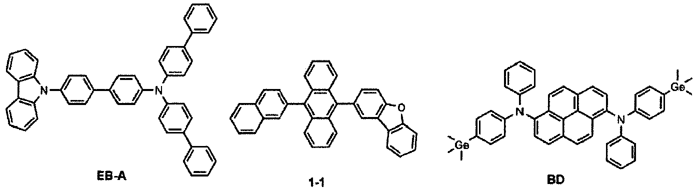

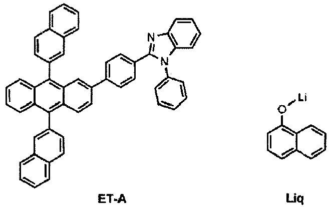

### Examples 1-2 to 1-9

An organic light emitting device was manufactured in the same manner as in Example 1-1, except that the compounds shown in Table 1 below were used as the hole transport layer materials and the host materials in Example 1-1.

### Comparative Examples 1-1 to 1-5

An organic light emitting device was manufactured in the same manner as in Example 1-1, except that the compounds shown in Table 1 below were used as the hole transport layer materials and the host materials in Example 1-1. In Table 1, NPB, HT-A, HT-B and BH-A are as follows, respectively.

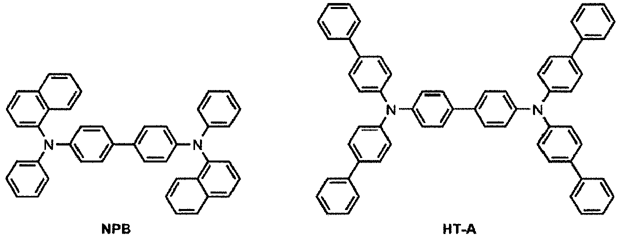

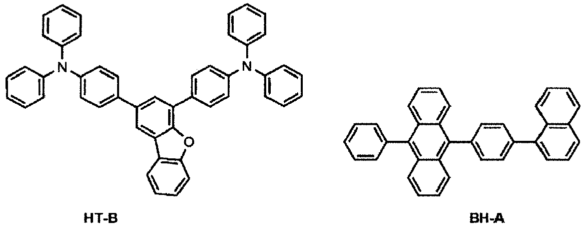

The device performance was measured at the current density of 10 mA/cm² for the organic light emitting devices manufactured in Examples and Comparative Examples, and the time required for the initial luminance to decrease to 98% of its initial value at a current density of 20 mA/cm² was measured. The results are shown in Table 1 below.

**[Table 1]**

| Example | Hole transport layer | Host | @10mA/cm² | | | | @20mA/c m² |
|---|---|---|---|---|---|---|---|
| | | | V | cd/A | CIE-x | CIE-y | Lifetime(h r) |
| Example 1-1 | Compound 2-1 | Compound 1-1 | 3.75 | 5.21 | 0.138 | 0.130 | 150 |
| Example 1-2 | Compound 2-1 | Compound 1-2 | 3.83 | 5.13 | 0.138 | 0.130 | 141 |
| Example 1-3 | Compound 2-2 | Compound 1-1 | 3.89 | 5.28 | 0.139 | 0.131 | 166 |
| Example 1-4 | Compound 2-2 | Compound 1-2 | 3.88 | 5.31 | 0.138 | 0.129 | 148 |
| Example 1-5 | Compound 2-2 | Compound 1-3 | 3.90 | 5.22 | 0.139 | 0.131 | 151 |
| Example 1-6 | Compound 2-2 | Compound 1-4 | 3.91 | 5.36 | 0.137 | 0.129 | 152 |
| Example 1-7 | Compound 2-3 | Compound 1-3 | 3.90 | 5.24 | 0.138 | 0.132 | 161 |
| Example 1-8 | Compound 2-3 | Compound 1-4 | 3.91 | 5.18 | 0.138 | 0.131 | 150 |
| Example 1-9 | Compound | Compound | 3.88 | 5.29 | 0.137 | 0.130 | 140 |
| | 2-4 | 1-1 | | | | | |
| Comparative Example 1-1 | NPB | BH-A | 4.54 | 4.35 | 0.138 | 0.130 | 100 |
| Comparative Example 1-2 | Compound 2-1 | BH-A | 4.51 | 4.91 | 0.138 | 0.132 | 60 |
| Comparative Example 1-3 | Compound 2-4 | BH-A | 4.67 | 4.92 | 0.138 | 0.130 | 63 |
| Comparative Example 1-4 | HT-A | Compound 1-1 | 3.99 | 3.15 | 0.137 | 0.130 | 31 |
| Comparative Example 1-5 | HT-B | Compound 1-3 | 3.93 | 4.18 | 0.140 | 0.131 | 55 |

As shown in Table 1, it was confirmed that the compounds represented by Chemical Formula 1 of the present invention exhibits low voltage characteristics when used as a host material in the light emitting layer. In addition, the compounds represented by Chemical Formula 2 have excellent electron transporting characteristics, and when applied to an electron transport layer, a highly efficient device can be obtained. Particularly, when both of them are applied at the same time, it was confirmed that balance of the hole and electron in the light emitting layer is well matched, so that it has remarkable effect in not only voltage and efficiency but also lifetime.

### [Example 2]

### Example 2-1

A glass substrate on which ITO (indium tin oxide) was coated as a thin film to a thickness of 1,400 Å was put into distilled water in which a detergent was dissolved, and ultrasonically cleaned. In this case, a product manufactured by Fischer Co., was used as the detergent, and as the distilled water, distilled water filtered twice using a filter manufactured by Millipore Co., was used. After the ITO was cleaned for 30 minutes, ultrasonic cleaning was repeated twice using distilled water for 10 minutes. After the cleaning with distilled water was completed, the substrate was ultrasonically cleaned with solvents of isopropyl alcohol, acetone, and methanol, then dried, and then transferred to a plasma cleaner. In addition, the substrate was cleaned for 5 minutes using oxygen plasma, and then transferred to a vacuum depositor.

On the ITO transparent electrode thus prepared, a compound represented by Formula HI-A below and a compound represented by Formula HAT below were sequentially subjected to thermal vacuum-deposition in a thickness of 650 Å and 50 Å, respectively, to form a hole injection layer. A compound represented by Formula NBP below was vacuum-deposited thereon in a thickness of 600 Å as a hole transport layer, and then Compound 2-1 prepared in the previous Preparation Example 2-1 was thermally vacuum-deposited in a thickness of 50 Å as an electron blocking layer. Then, the Compound 1-1 prepared in the previous Preparation Example 1-1 and a compound represented by Formula BD below were vacuum-deposited at a weight ratio of 96: 4 as a light emitting layer in a thickness of 200 Å. Then, a compound represented by Formula ET-A below and a compound represented by Formula Liq below were thermally vacuum-deposited at a weight ratio of 1:1 in a thickness of 360 Å as an electron transport layer and an electron injection layer, and then a compound represented by Formula Liq below was vacuum-deposited in a thickness of 5 Å. Magnesium and silver were sequentially deposited at a weight ratio of 10: 1 on the electron injection layer in a thickness of 220 Å, and aluminum was deposited in a thickness of 1000 Å to form a cathode, thereby manufacturing an organic light emitting device.

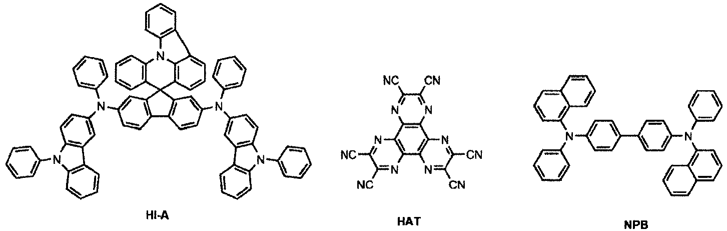

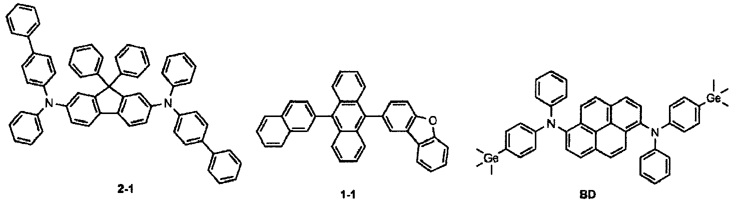

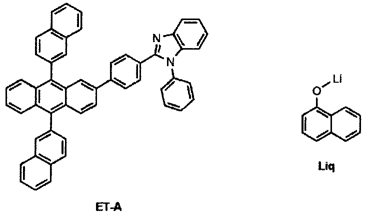

### Examples 2-2 to 2-8

An organic light emitting device was manufactured in the same manner as in Example 2-1, except that the compounds shown in Table 2 below were used as the electron blocking layer materials and the host materials in Example 2-1.

### Comparative Examples 2-1 to 2-6

The organic light emitting device was manufactured in the same manner as in Example 2-1, except that the compounds shown in Table 2 below were used as the electron blocking layer materials and the host materials in Example 2-1. In Table 2, EB-A, EB-B, HT-A, HT-B, and BH-A are as follows, respectively.

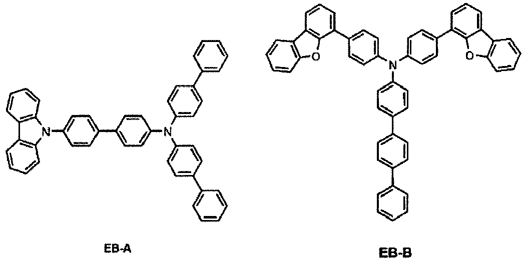

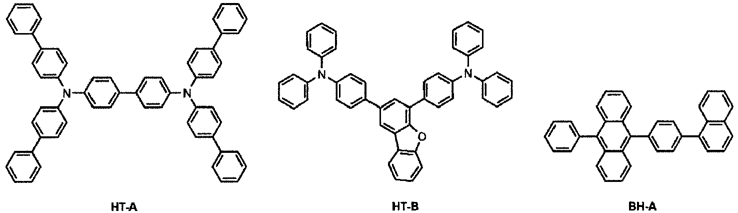

The device performance was measured at the current density of 10 mA/cm² for the organic light emitting devices manufactured in Examples and Comparative Examples, and the time required for the initial luminance to decrease to 90% of its initial value at a current density of 20 mA/cm² was measured. The results are shown in Table 2 below.

**[Table 2]**

| Example | Electron blocking layer | Host | @10mA/cm² | | | | @20mA/c m² |
|---|---|---|---|---|---|---|---|
| | | | V | cd/A | CIE-x | CIE-y | Lifetime(h r) |
| Example 2-1 | Compound 2-1 | Compound 1-1 | 3.65 | 5.15 | 0.138 | 0.130 | 151 |
| Example 2-2 | Compound 2-1 | Compound 1-2 | 3.66 | 5.16 | 0.138 | 0.129 | 146 |
| Example 2-3 | Compound 2-2 | Compound 1-2 | 3.51 | 5.13 | 0.138 | 0.130 | 150 |
| Example 2-4 | Compound 2-2 | Compound 1-4 | 3.52 | 5.28 | 0.139 | 0.130 | 164 |
| Example 2-5 | Compound 2-3 | Compound 1-1 | 3.66 | 5.18 | 0.137 | 0.130 | 144 |
| Example 2-6 | Compound 2-3 | Compound 1-3 | 3.58 | 5.27 | 0.139 | 0.131 | 152 |
| Example 2-7 | Compound 2-4 | Compound 1-3 | 3.71 | 5.10 | 0.138 | 0.130 | 154 |
| Example 2-8 | Compound 2-4 | Compound 1-4 | 3.50 | 5.10 | 0.138 | 0.131 | 151 |
| Comparative | EB-A | BH-A | 4.35 | 4.83 | 0.138 | 0.130 | 86 |
| Example 2-1 | | | | | | | |
| Comparative Example 2-2 | EB-B | BH-A | 4.21 | 4.78 | 0.140 | 0.134 | 80 |
| Comparative Example 2-3 | Compound 2-1 | BH-A | 3.75 | 4.01 | 0.142 | 0.132 | 74 |
| Comparative Example 2-4 | Compound 2-4 | BH-A | 3.81 | 4.28 | 0.139 | 0.130 | 76 |
| Comparative Example 2-5 | HT-A | Compound 1-1 | 4.57 | 4.04 | 0.139 | 0.141 | 27 |
| Comparative Example 2-6 | HT-B | Compound 1-2 | 4.89 | 4.55 | 0.138 | 0.132 | 38 |

As shown in Table 2, it was confirmed that, when the compounds represented by Chemical Formula 1 of the present invention as a host material is used in combination with the compound represented by Chemical Formula 2 as a hole blocking material, a remarkable effect in terms of voltage, efficiency, and lifetime can be obtained. That is, it is confirmed that the efficiency, and lifetime are improved not only when the compounds represented by Chemical Formula 2 of the present invention were used as an electron transport layer but also when they are applied as a hole blocking layer.

**[Description of symbols]**

| | |
|---|---|
| 1: substrate | 2: anode |
| 3: hole transport region | 4: light emitting layer |
| 5: cathode | 6: hole transport layer |
| 7: electron blocking layer | 8: electron transport layer |

## Claims

1. An organic light emitting device comprising:
an anode (2);
a cathode (5);
a light emitting layer (4) disposed between the anode (2) and the cathode (5); and
a hole transport region (3) between the anode (2) and the light emitting layer (4),
wherein the light emitting layer (4) comprises a compound represented by the following Chemical Formula 1, and
wherein the hole transport region comprises a compound represented by the following Chemical Formula 2: 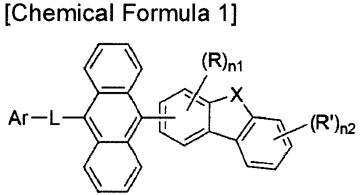 in Chemical Formula 1,
X is O, or S,
L is a bond; or a substituted or unsubstituted C₆₋₆₀ arylene,
Ar is a substituted or unsubstituted C₆₋₆₀ aryl,
R and R' are each independently hydrogen; deuterium; halogen; nitrile; nitro; amino; a substituted or unsubstituted C₁₋₆₀ alkyl; a substituted or unsubstituted C₃₋₆₀ cycloalkyl; a substituted or unsubstituted C₂₋₆₀ alkenyl group; a substituted or unsubstituted C₆₋₆₀ aryl; or a substituted or unsubstituted C₂₋₆₀ heteroaryl containing at least one heteroatom selected from the group consisting of N, O and S,
n1 is an integer of 0 to 3, and
n2 is an integer of 0 to 4, 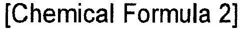 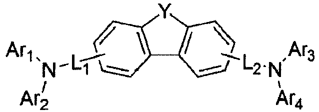
in Chemical Formula 2,
L₁ and L₂ are each independently a bond; or a substituted or unsubstituted C₆₋₆₀ arylene,
Ar₁ to Ar₄ are each independently a substituted or unsubstituted C₆₋₆₀ aryl,
Y is CR₁R₂, NR₁, O, S, or SiR₁R₂,
R₁ and R₂ are each independently a substituted or unsubstituted C₁₋₆₀ alkyl, or -L₃-Ar₅,
L₃ is a bond; or a substituted or unsubstituted C₆₋₆₀ arylene, and
Ar₅ is a substituted or unsubstituted C₆₋₆₀ aryl, or a substituted or unsubstituted C₂₋₆₀ heteroaryl containing at least one heteroatom selected from the group consisting of N, O and S.

2. The organic light emitting device according to claim 1, wherein
L is a bond, phenylene, biphenylylene, naphthylene, or anthracenylene.

3. The organic light emitting device according to claim 1, wherein
Ar is phenyl, biphenylyl, terphenylyl, naphthyl, phenylnaphthyl, naphthylphenyl, or phenanthrenyl.

4. The organic light emitting device according to claim 1, wherein
R and R' are each independently hydrogen, deuterium, phenyl, biphenylyl, or naphthyl.

5. The organic light emitting device according to claim 1,
wherein the compound represented by Chemical Formula 1 is any one selected from the group consisting of the following:

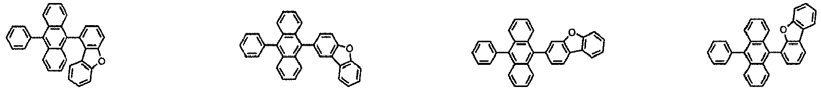

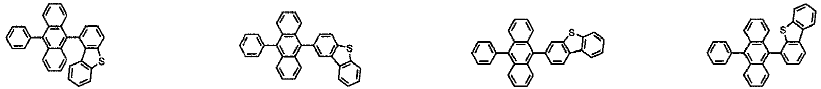

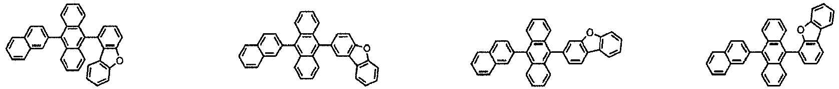

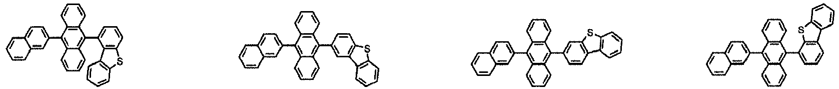

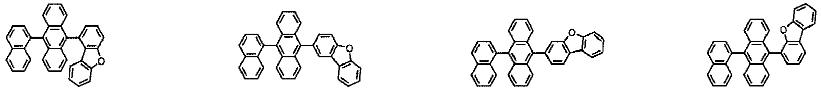

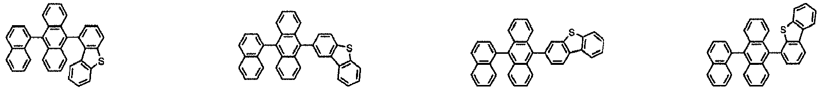

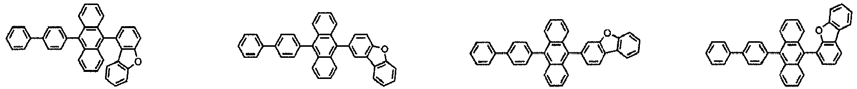

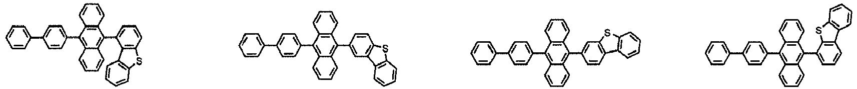

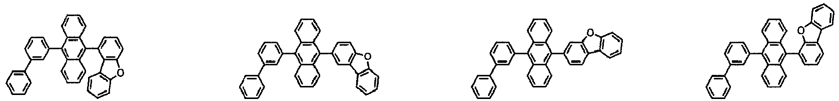

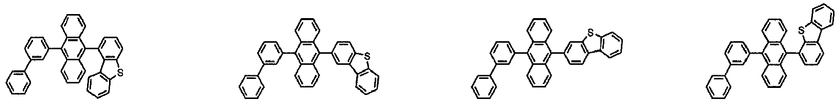

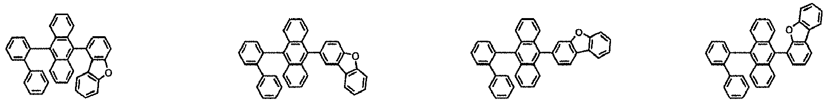

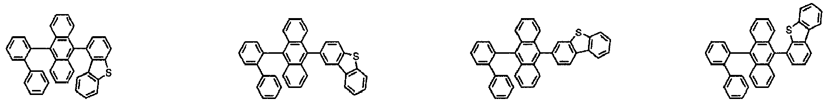

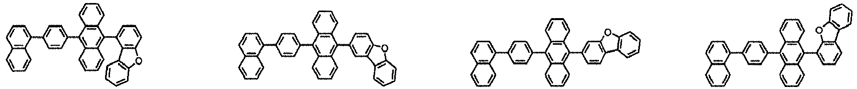

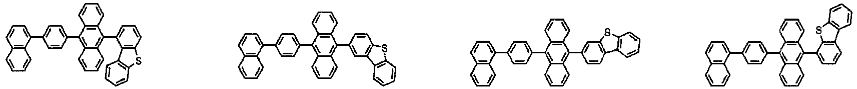

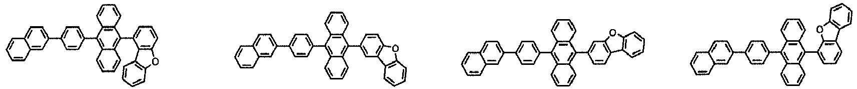

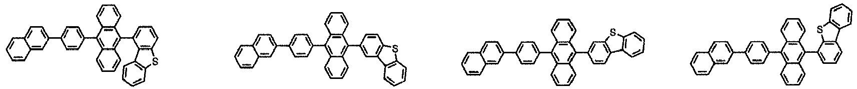

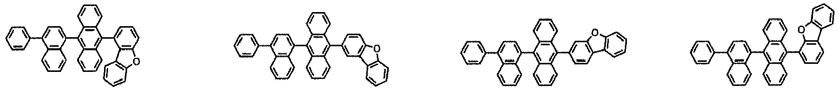

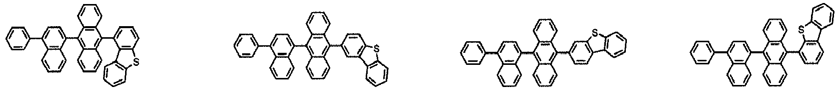

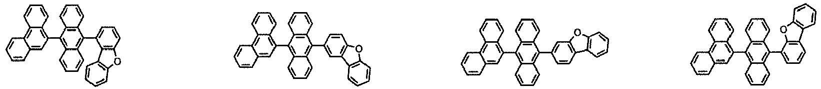

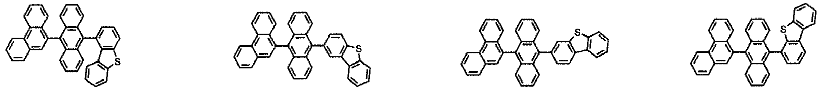

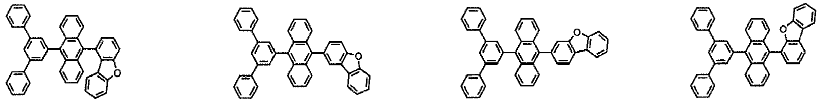

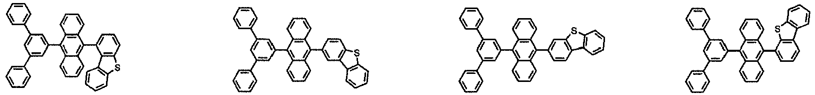

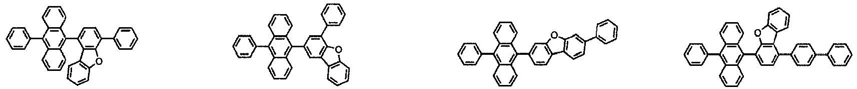

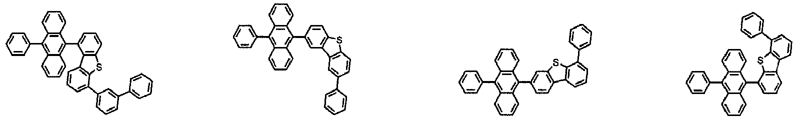

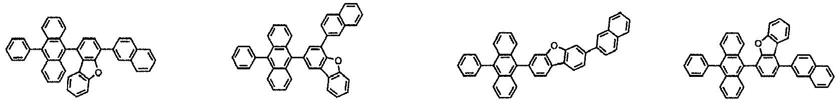

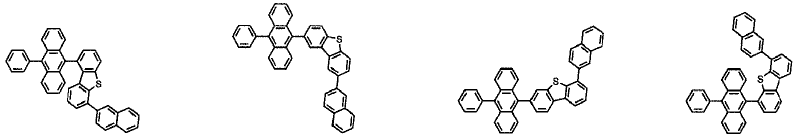

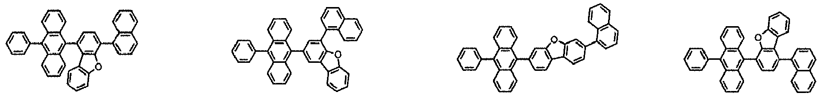

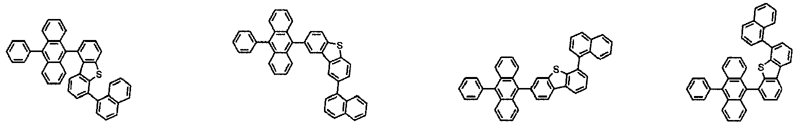

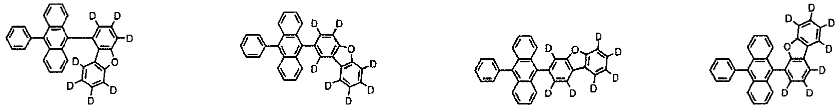

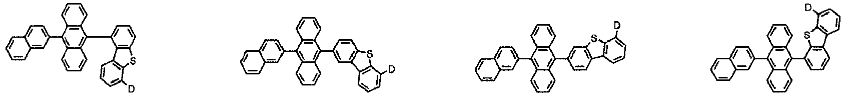

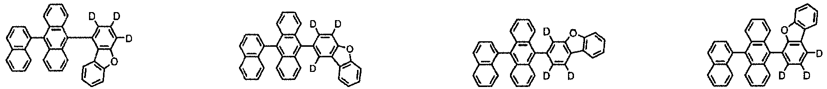

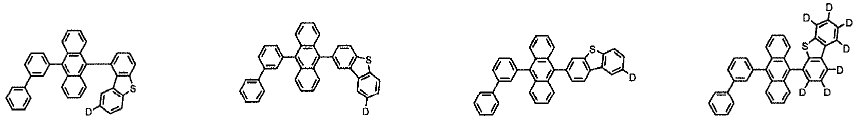

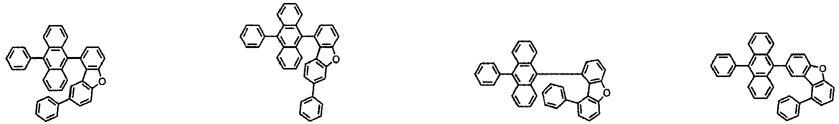

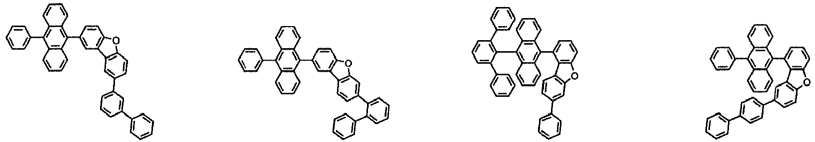

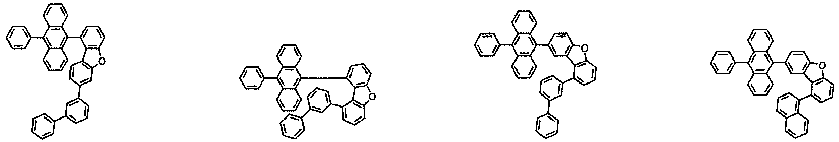

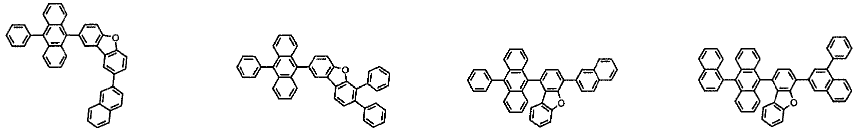

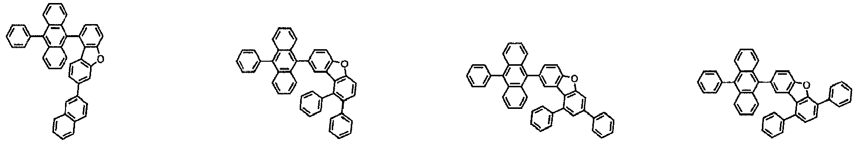

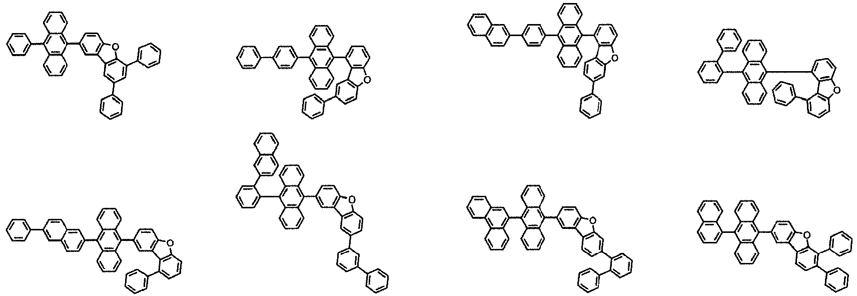

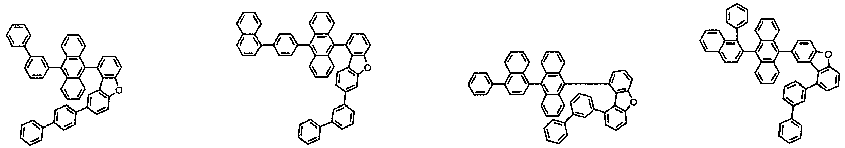

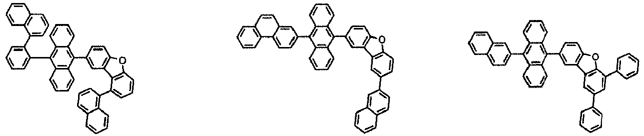

6. The organic light emitting device according to claim 1, wherein
L₁ and L₂ are each independently a bond, or phenylene.

7. The organic light emitting device according to claim 1, wherein
Ar₁ to Ar₄ are each independently phenyl, biphenylyl, or terphenylyl.

8. The organic light emitting device according to claim 1, wherein
R₁ and R₂ are each independently methyl, phenyl, naphthyl, benzofuranyl, phenanthrenyl, naphthylphenyl, or benzofuranylphenyl.

9. The organic light emitting device according to claim 1, wherein
the compound represented by Chemical Formula 2 is any one selected from the group consisting of the following:

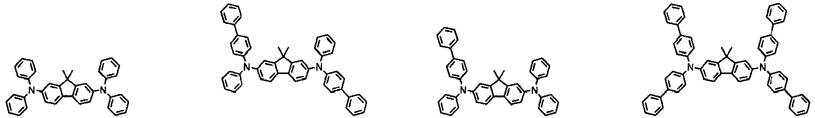

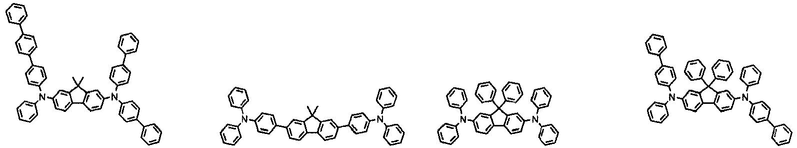

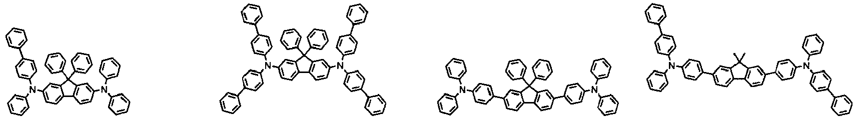

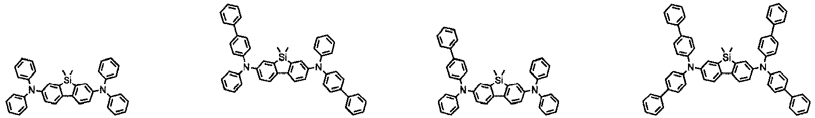

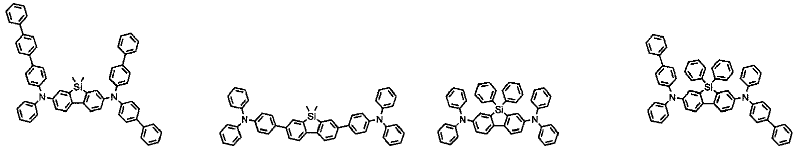

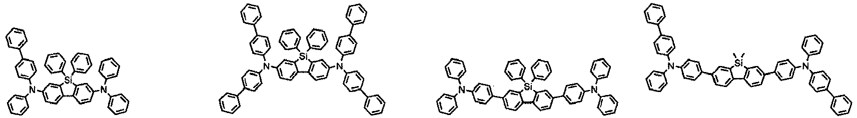

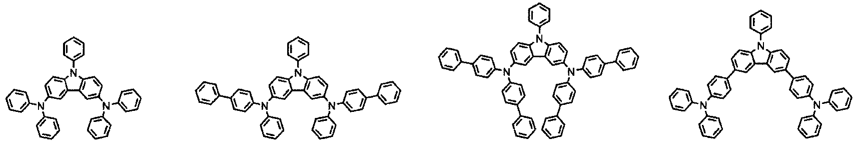

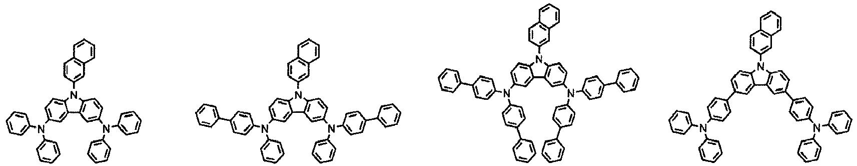

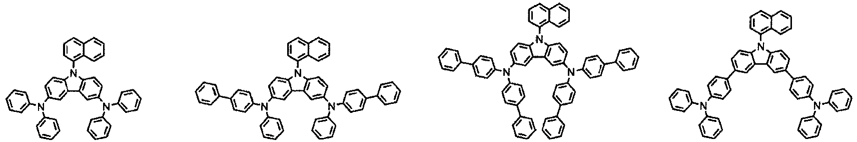

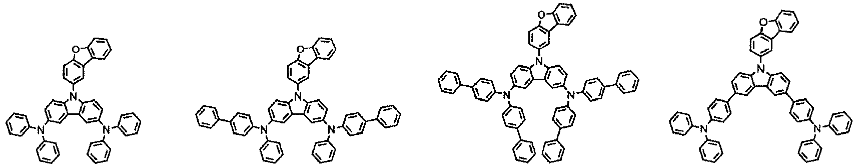

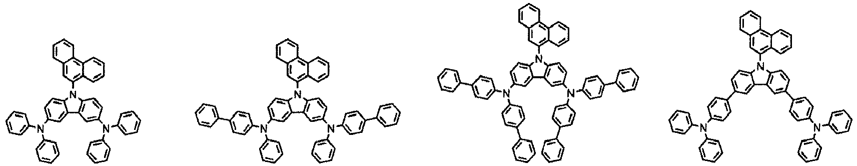

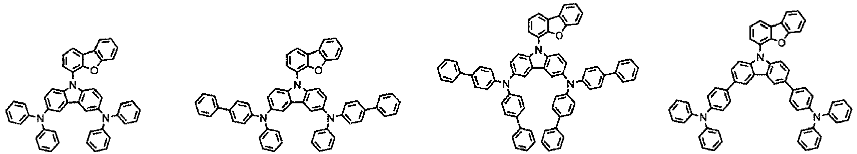

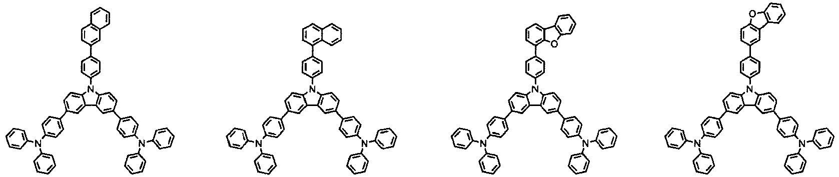

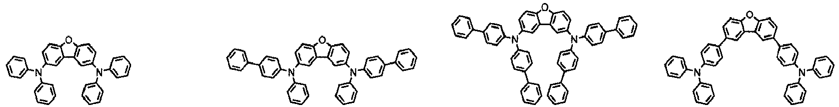

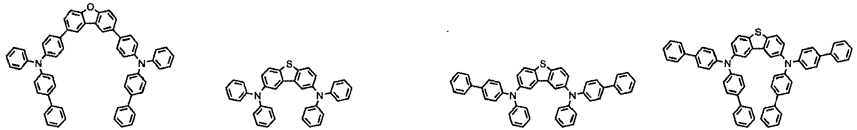

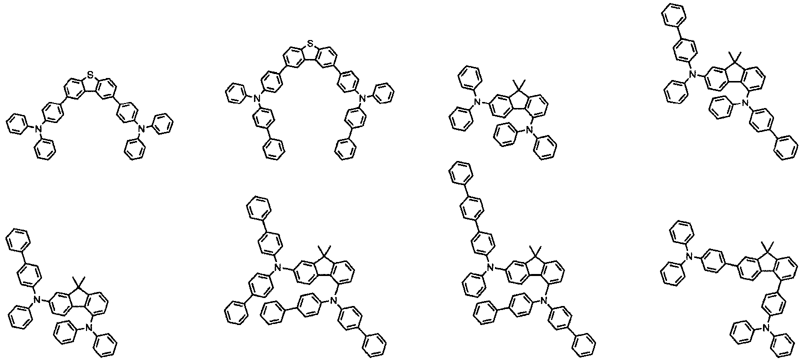

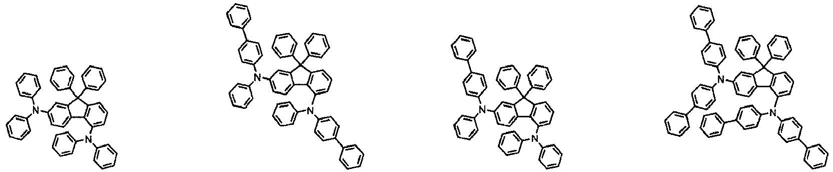

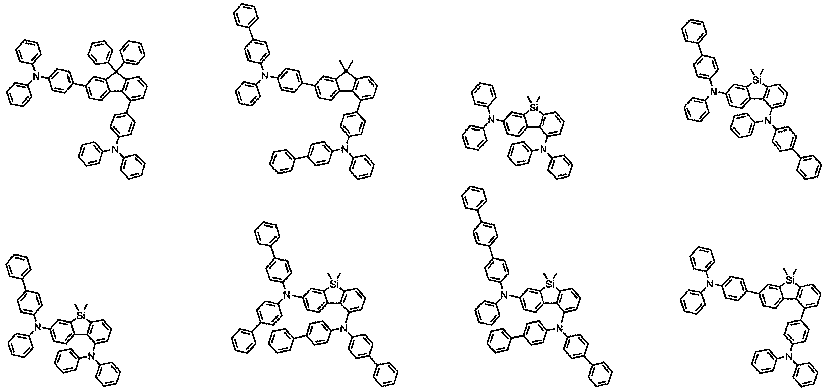

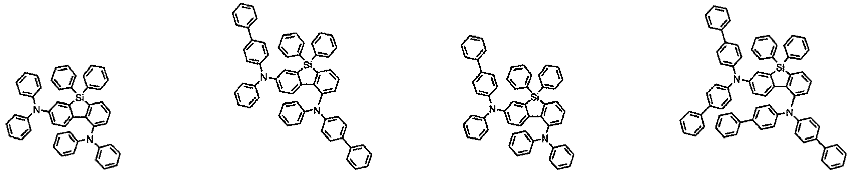

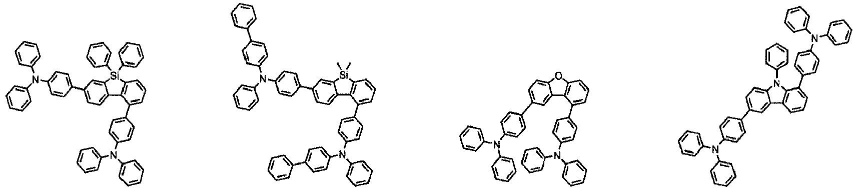

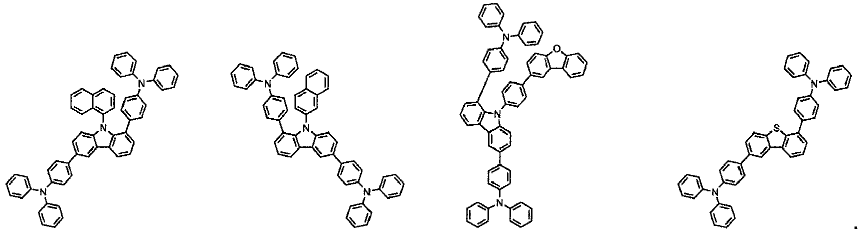

10. The organic light emitting device according to claim 1, wherein the hole transport region (3) comprises a hole transport layer (6), and the hole transport layer (6) comprises the compound represented by Chemical Formula 2.

11. The organic light emitting device according to claim 1, wherein
the hole transport region (3) comprises a hole transport layer (6) and an electron blocking layer (7), and
the electron blocking layer (7) comprises the compound represented by Chemical Formula 2.

12. The organic light emitting device according to claim 11, wherein
the light emitting layer (4) and the electron blocking layer (7) are positioned adjacent to each other.

## Patentansprüche

1. Organische lichtemittierende Vorrichtung, umfassend:
eine Anode (2),
eine Kathode (5),
eine lichtemittierende Schicht (4), die zwischen der Anode (2) und der Kathode (5) angeordnet ist, und
einen Lochtransportbereich (3) zwischen der Anode (2) und der lichtemittierenden Schicht (4),
wobei die lichtemittierende Schicht (4) eine durch die folgende chemische Formel 1 dargestellte Verbindung umfasst und
wobei der Lochtransportbereich eine durch die folgende chemische Formel 2 dargestellte Verbindung umfasst: 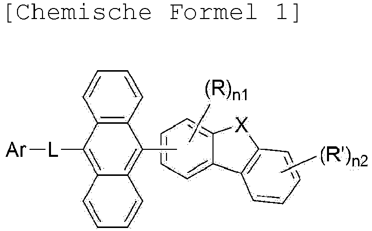 in der chemischen Formel 1
ist X O oder S,
L ist eine Bindung oder ein substituiertes oder unsubstituiertes C₆₋₆₀-Arylen,
Ar ist ein substituiertes oder unsubstituiertes C₆₋₆₀-Aryl,
R und R' sind jeweils unabhängig Wasserstoff, Deuterium, Halogen, Nitril, Nitro, Amino, ein substituiertes oder unsubstituiertes C₁₋₆₀-Alkyl, ein substituiertes oder unsubstituiertes C₃₋₆₀-Cycloalkyl, eine substituierte oder unsubstituierte C₂₋₆₀-Alkenylgruppe, ein substituiertes oder unsubstituiertes C₆₋₆₀-Aryl oder ein substituiertes oder unsubstituiertes C₂₋₆₀-Heteroaryl, das mindestens ein Heteroatom, ausgewählt aus der Gruppe, bestehend aus N, 0 und S, enthält,
n1 ist eine ganze Zahl von 0 bis 3 und
n2 ist eine ganze Zahl von 0 bis 4, 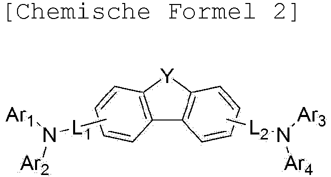
in der chemischen Formel 2
sind L₁ und L₂ jeweils unabhängig eine Bindung oder ein substituiertes oder unsubstituiertes C₆₋₆₀-Arylen,
Ar₁ bis Ar₄ sind jeweils unabhängig ein substituiertes oder unsubstituiertes C₆₋₆₀-Aryl,
Y ist CR₁R₂, NR₁, 0, S oder SiR₁R₂,
R₁ und R₂ sind jeweils unabhängig ein substituiertes oder unsubstituiertes C₁₋₆₀-Alkyl oder -L₃-Ar₅,
L₃ ist eine Bindung oder ein substituiertes oder unsubstituiertes C₆₋₆₀-Arylen und
Ar₅ ist ein substituiertes oder unsubstituiertes C₆₋₆₀-Aryl oder ein substituiertes oder unsubstituiertes C₂₋₆₀-Heteroaryl, das mindestens ein Heteroatom, ausgewählt aus der Gruppe, bestehend aus N, 0 und S, enthält.

2. Organische lichtemittierende Vorrichtung gemäß Anspruch 1, wobei
L eine Bindung, Phenylen, Biphenylylen, Naphthylen oder Anthracenylen ist.

3. Organische lichtemittierende Vorrichtung gemäß Anspruch 1, wobei
Ar Phenyl, Biphenylyl, Terphenylyl, Naphthyl, Phenylnaphthyl, Naphthylphenyl oder Phenanthrenyl ist.

4. Organische lichtemittierende Vorrichtung gemäß Anspruch 1, wobei
R und R' jeweils unabhängig Wasserstoff, Deuterium, Phenyl, Biphenylyl oder Naphthyl sind.

5. Organische lichtemittierende Vorrichtung gemäß Anspruch 1,
wobei die durch die chemische Formel 1 dargestellte Verbindung irgendeine, ausgewählt aus der Gruppe, bestehend aus den Folgenden, ist:

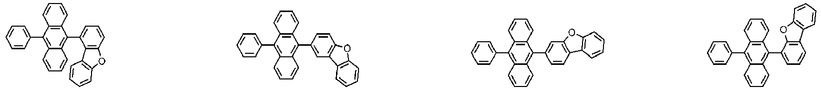

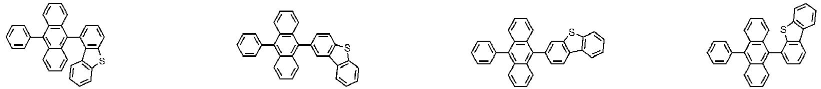

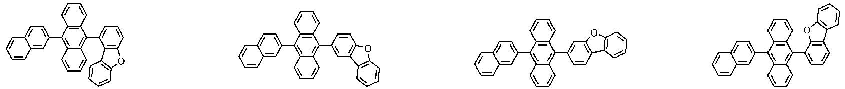

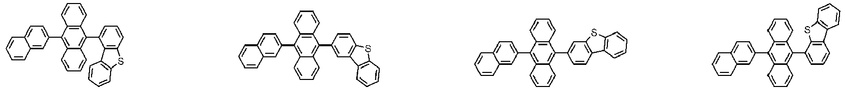

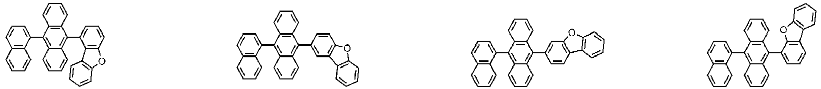

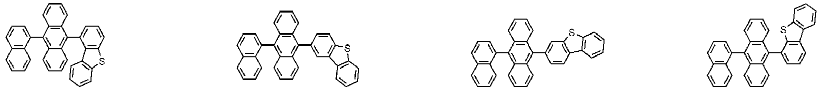

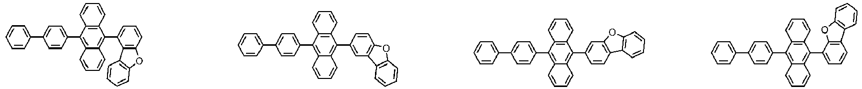

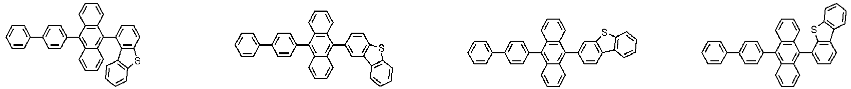

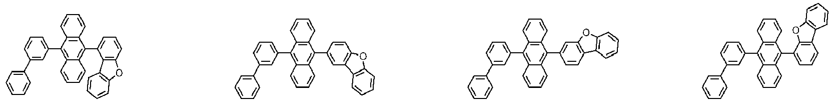

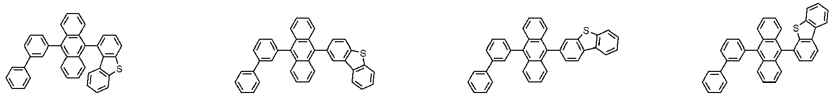

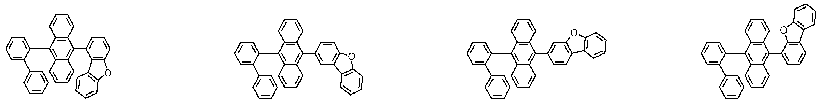

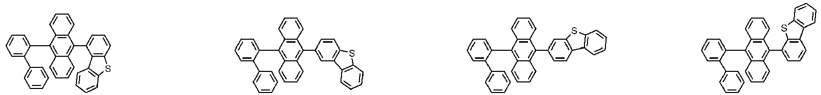

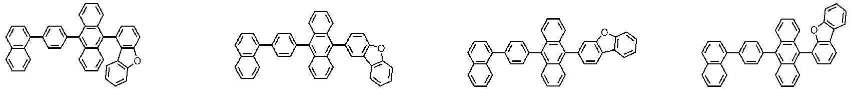

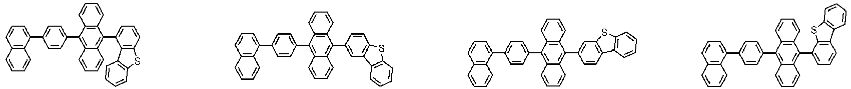

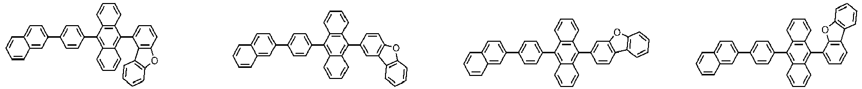

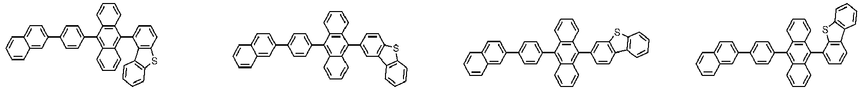

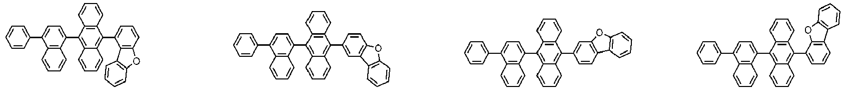

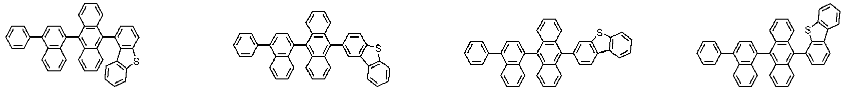

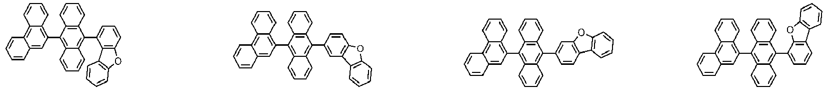

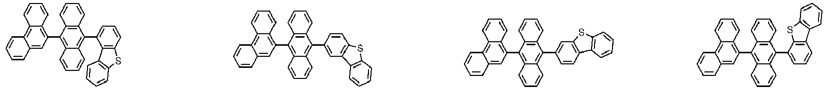

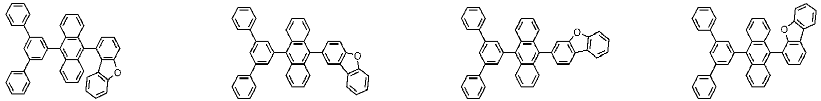

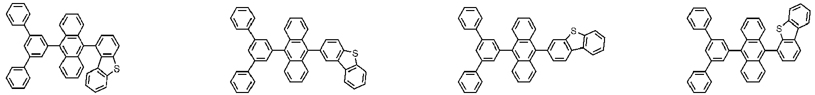

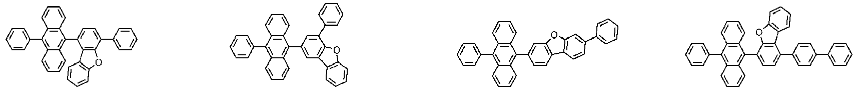

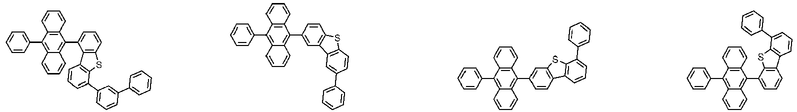

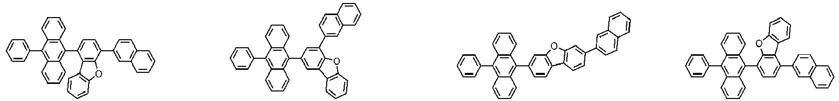

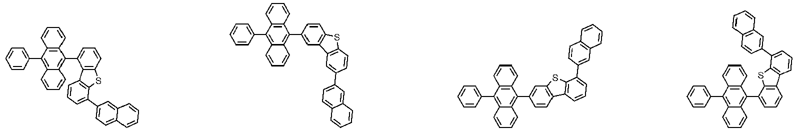

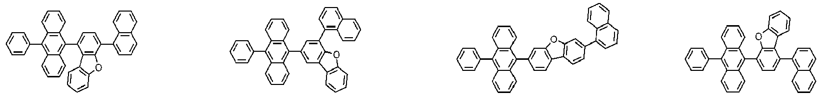

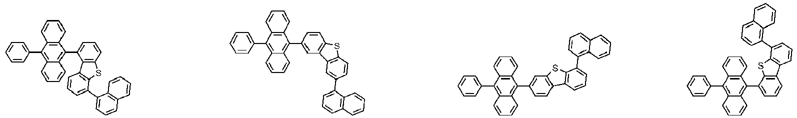

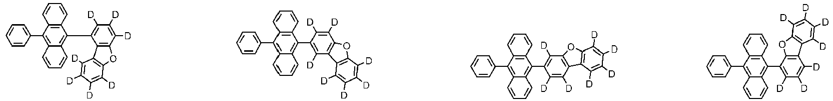

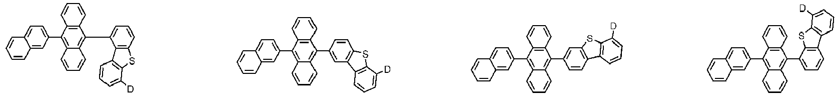

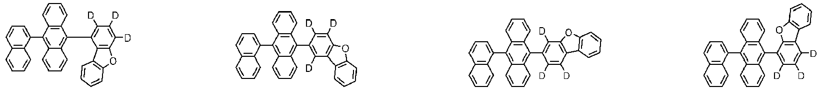

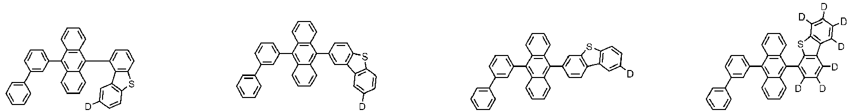

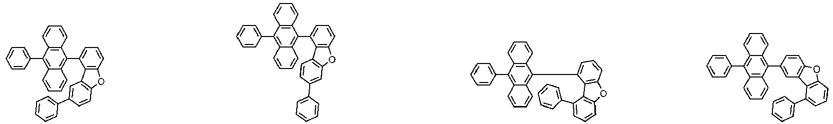

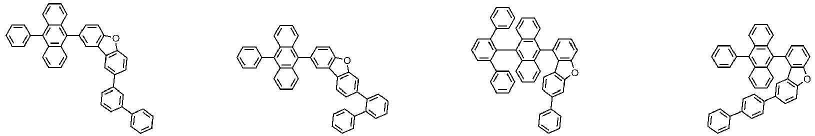

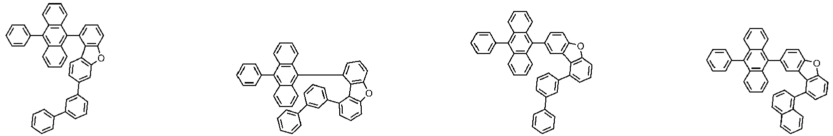

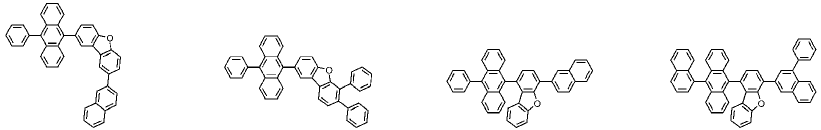

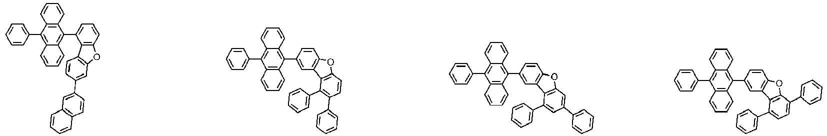

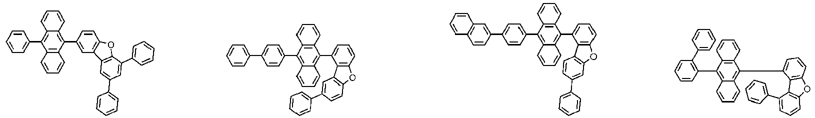

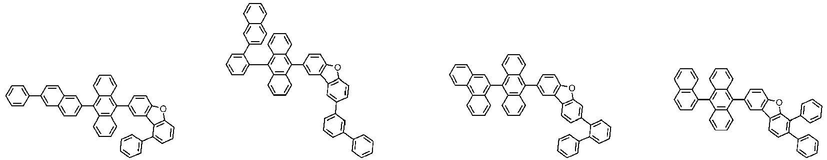

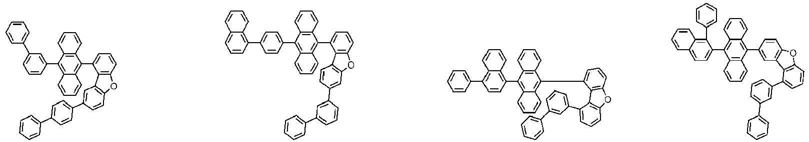

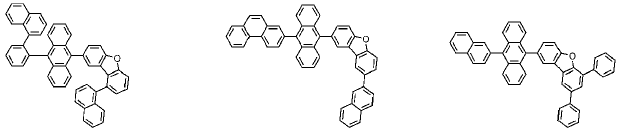

6. Organische lichtemittierende Vorrichtung gemäß Anspruch 1, wobei
L₁ und L₂ jeweils unabhängig eine Bindung oder Phenylen sind.

7. Organische lichtemittierende Vorrichtung gemäß Anspruch 1, wobei
Ar₁ und Ar₄ jeweils unabhängig Phenyl, Biphenylyl oder Terphenylyl sind.

8. Organische lichtemittierende Vorrichtung gemäß Anspruch 1, wobei
R₁ und R₂ jeweils unabhängig Methyl, Phenyl, Naphthyl, Benzofuranyl, Phenanthrenyl, Naphthylphenyl oder Benzofuranylphenyl sind.

9. Organische lichtemittierende Vorrichtung gemäß Anspruch 1, wobei
die durch die chemische Formel 2 dargestellte Verbindung irgendeine, ausgewählt aus der Gruppe, bestehend aus den Folgenden, ist:

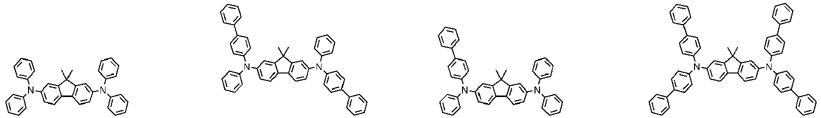

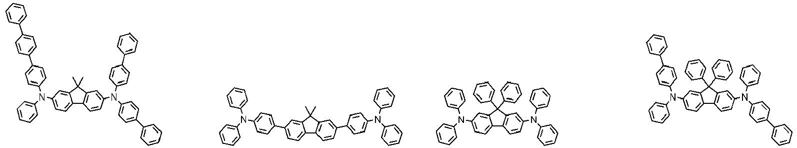

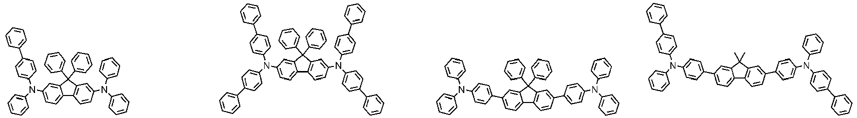

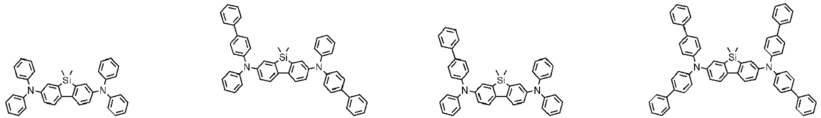

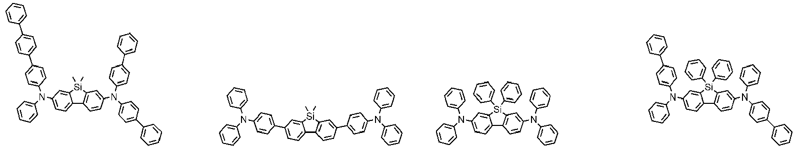

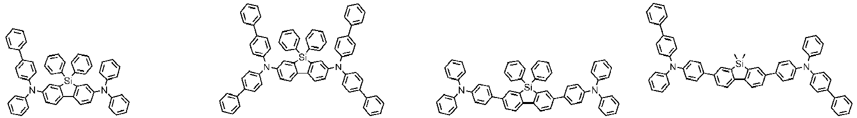

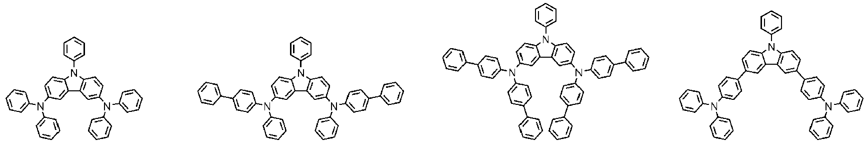

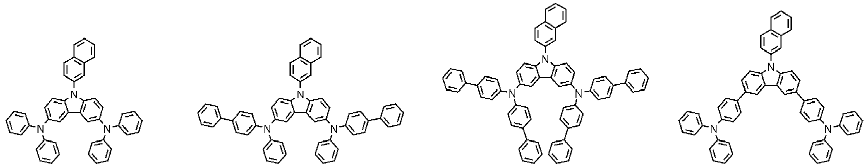

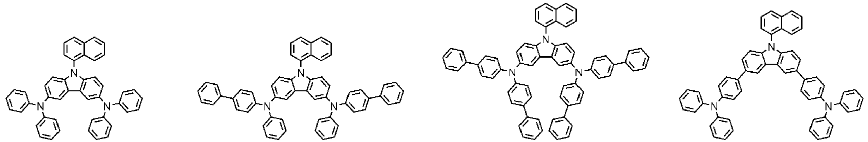

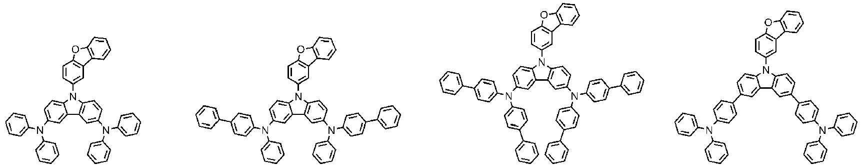

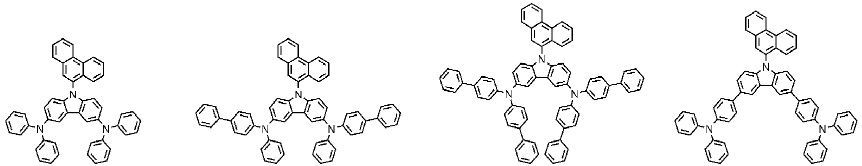

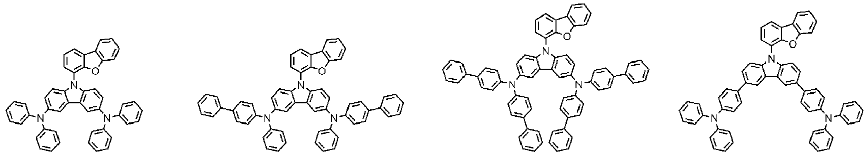

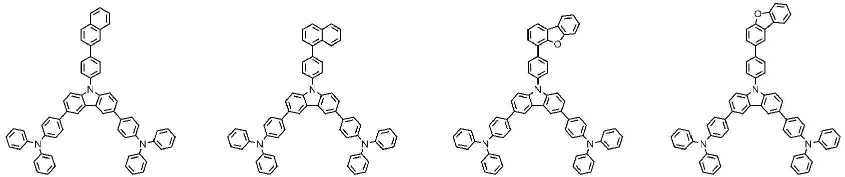

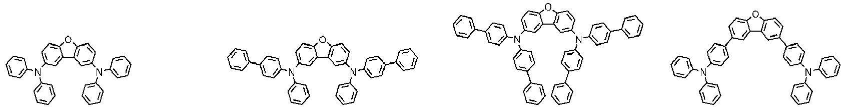

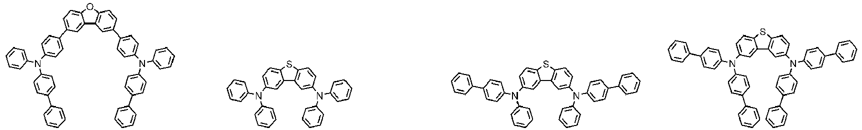

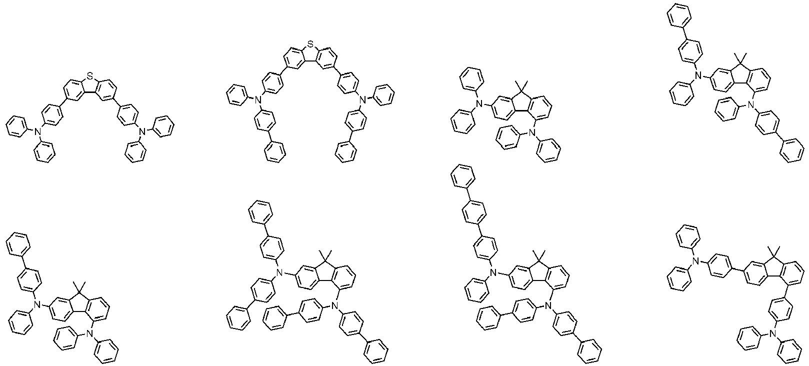

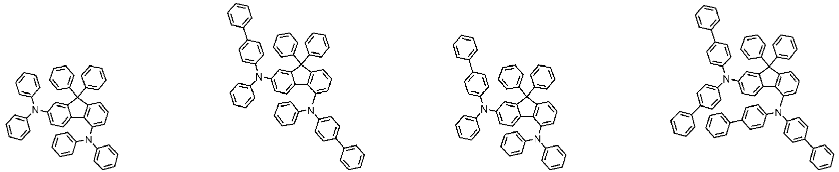

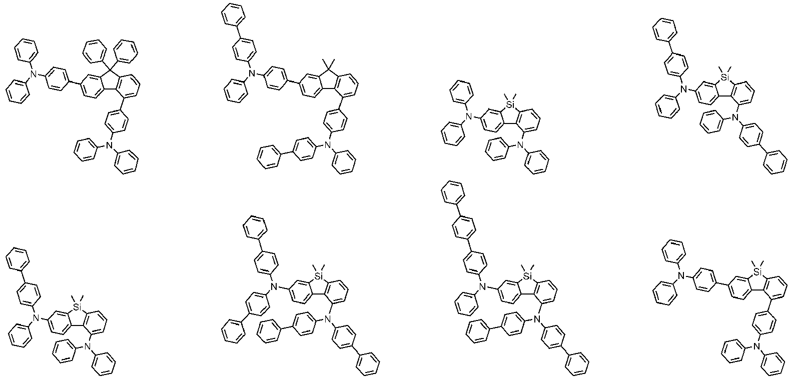

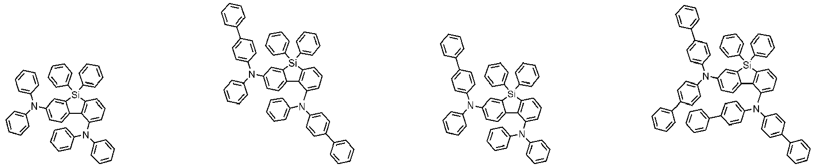

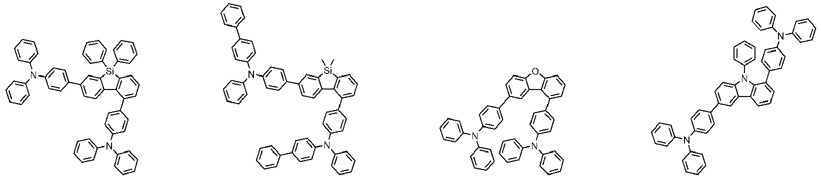

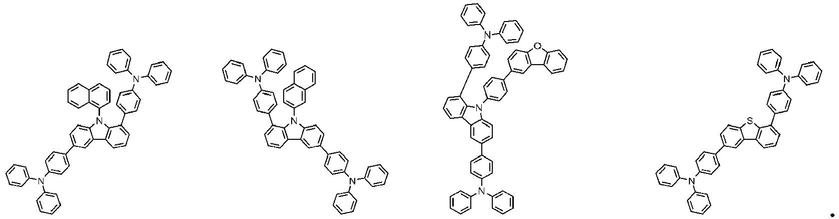

10. Organische lichtemittierende Vorrichtung gemäß Anspruch 1, wobei
der Lochtransportbereich (3) eine Lochtransportschicht (6) umfasst, und
die Lochtransportschicht (6) die durch die chemische Formel 2 dargestellte Verbindung umfasst.

11. Organische lichtemittierende Vorrichtung gemäß Anspruch 1, wobei
der Lochtransportbereich (3) eine Lochtransportschicht (6) und eine Elektronenblockierschicht (7) umfasst und
die Elektronenblockierschicht (7) die durch die chemische Formel dargestellte Verbindung umfasst.

12. Organische lichtemittierende Vorrichtung gemäß Anspruch 11, wobei
die lichtemittierende Schicht (4) und die Elektronenblockierschicht (7) aneinander angrenzend positioniert sind.

## Revendications

1. Dispositif électroluminescent organique comprenant :
une anode (2) ;
une cathode (5) ;
une couche électroluminescente (4) disposée entre l'anode (2) et la cathode (5) ; et
une région de transport de trous (3) entre l'anode (2) et la couche électroluminescente (4),
dans lequel la couche électroluminescente (4) comprend un composé représenté par la formule chimique 1 suivante, et
dans lequel la région de transport de trous comprend un composé représenté par la formule chimique 2 suivante : 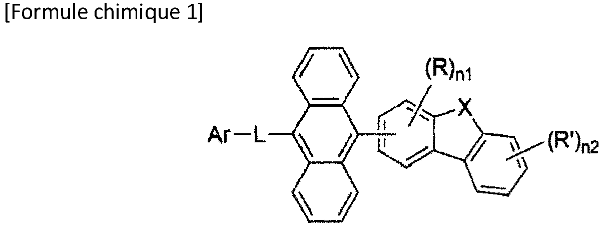 dans la formule chimique 1,
X est O, ou S,
L est une liaison ; ou un arylène en C₆₋₆₀ substitué ou non substitué,
Ar est un aryle en C₆₋₆₀ substitué ou non substitué,
R et R' sont chacun indépendamment un hydrogène; un deutérium ; un halogène ; un nitrile ; un nitro ; un amino ; un alkyle en C₁₋₆₀ substitué ou non substitué ; un cycloakyle en C₃₋₆₀ substitué ou non substitué ; un groupe alcényle en C₂₋₆₀ substitué ou non substitué ; un aryle en C₆₋₆₀ substitué ou non substitué ; ou un hétéroaryle en C₂₋₆₀ substitué ou non substitué contenant au moins un hétéroatome choisi dans le groupe constitué de N, O et S,
n1 est un entier de 0 à 3, et
n2 est un entier de 0 à 4, 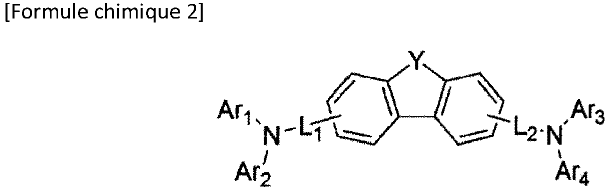
dans la formule chimique 2,
L₁ et L₂ sont chacun indépendamment une liaison ; ou un arylène en C₆₋₆₀ substitué ou non substitué,
Ar₁ à Ar₄ sont chacun indépendamment un aryle en C₆₋₆₀ substitué ou non substitué,
Y est CR₁R₂, NR₁, O, S ou SiR₁R₂,
R₁ et R₂ sont chacun indépendamment un alkyle en C₁₋₆₀ substitué ou non substitué, ou -L₃-Ar₅,
L₃ est une liaison, ou un arylène en C₆₋₆₀ substitué ou non substitué, et
Ar₅ est un aryle en C₆₋₆₀ substitué ou non substitué, ou un hétéroaryle en C₂₋₆₀ substitué ou non substitué contenant au moins un hétéroatome choisi dans le groupe constitué de N, O et S.

2. Dispositif électroluminescent organique selon la revendication 1, dans lequel L est une liaison, un phénylène, un biphénylylène, un naphtylène ou un anthracénylène.

3. Dispositif électroluminescent organique selon la revendication 1, dans lequel
Ar est un phényle, un biphénylyle, un terphénylyle, un naphtyle, un phénylnaphtyle, un naphtylphényle ou un phénanthrényle.

4. Dispositif électroluminescent organique selon la revendication 1, dans lequel
R et R' sont chacun indépendamment un hydrogène, un deutérium, un phényle, un biphénylyle ou un naphthyle.

5. Dispositif électroluminescent organique selon la revendication 1,
dans lequel le composé représenté par la formule chimique 1 est l'un quelconque choisi dans le groupe constitué des suivants :

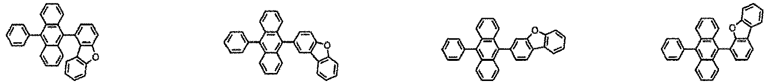

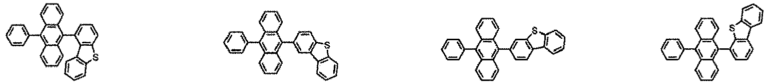

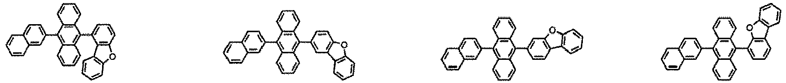

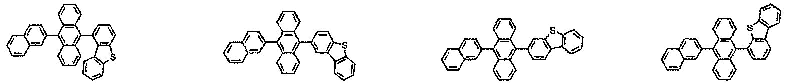

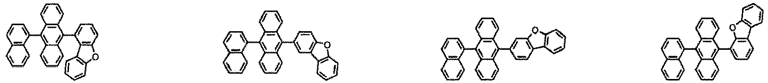

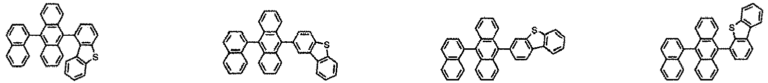

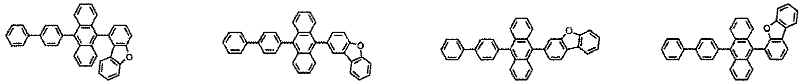

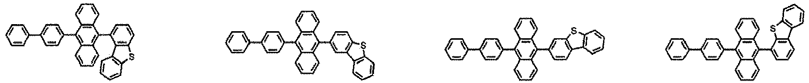

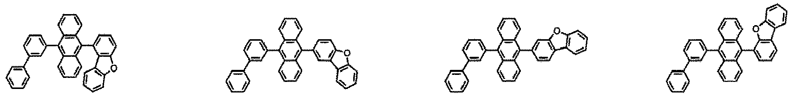

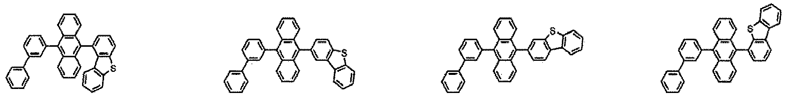

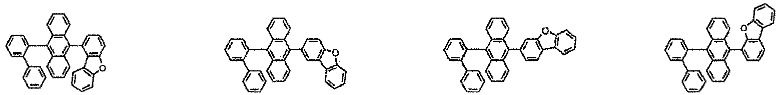

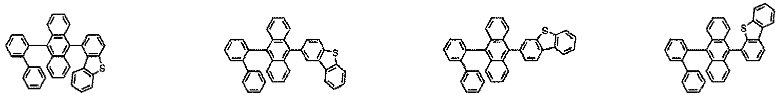

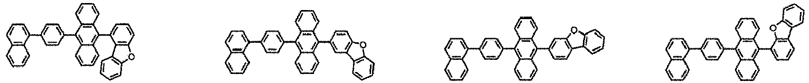

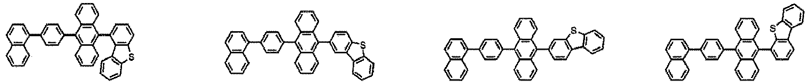

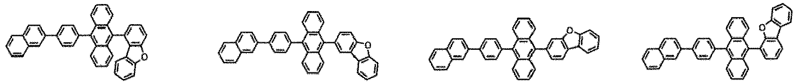

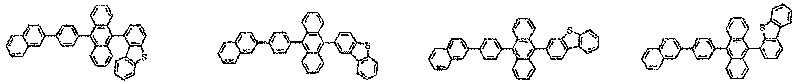

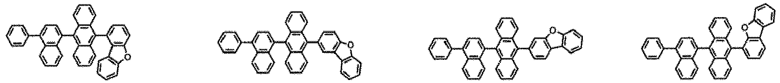

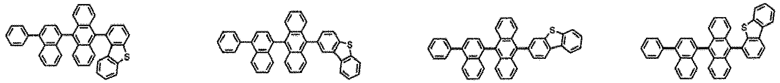

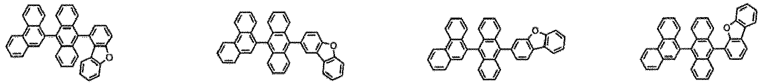

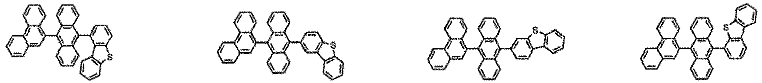

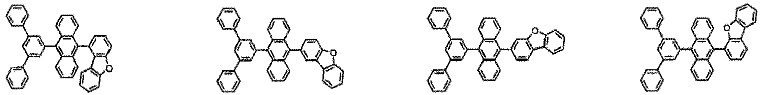

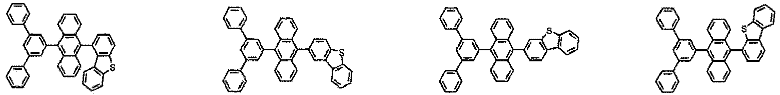

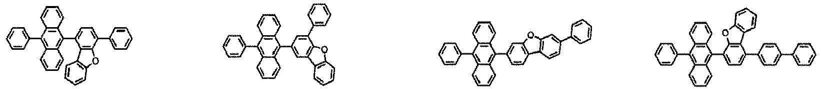

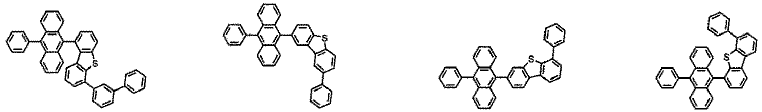

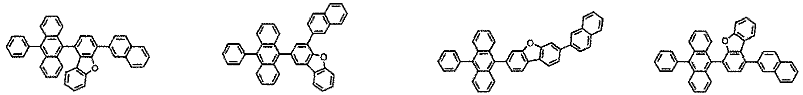

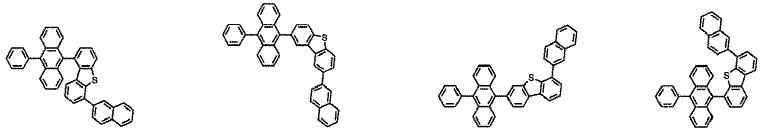

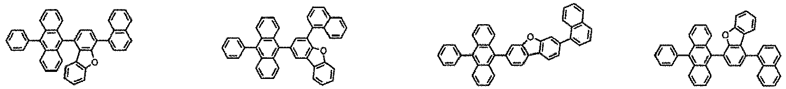

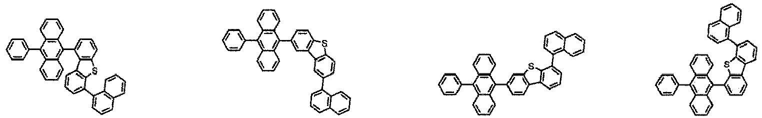

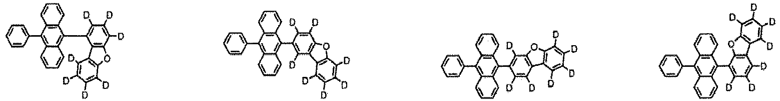

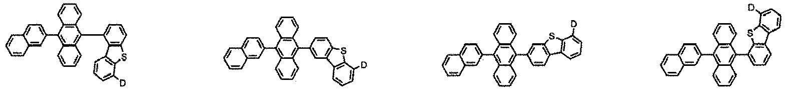

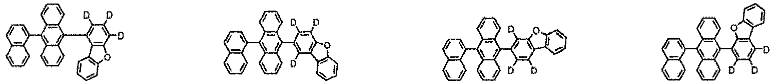

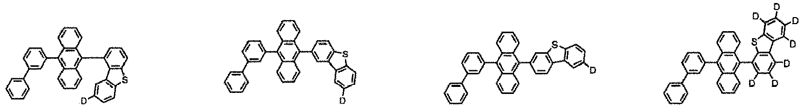

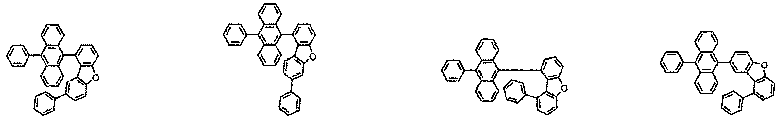

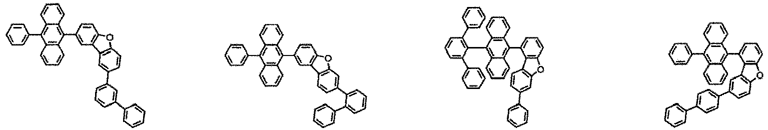

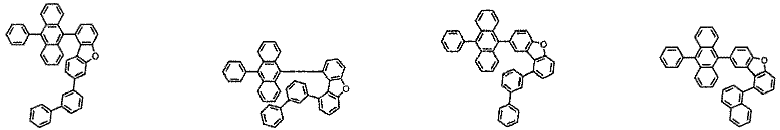

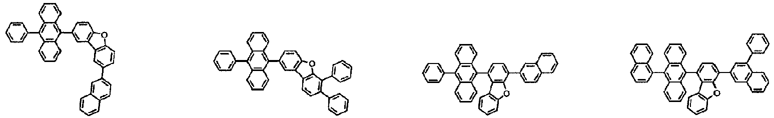

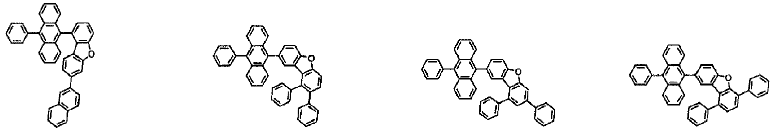

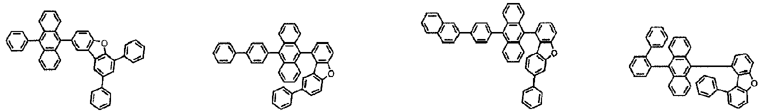

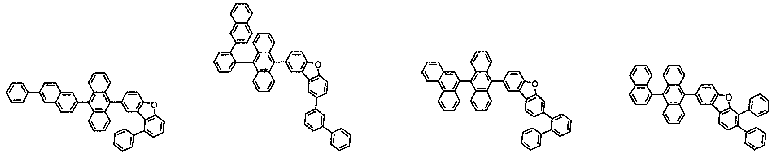

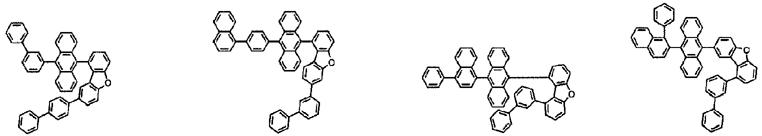

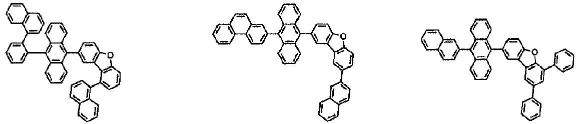

6. Dispositif électroluminescent organique selon la revendication 1, dans lequel
L₁ et L₂ sont chacun indépendamment une liaison, ou un phénylène.

7. Dispositif électroluminescent organique selon la revendication 1, dans lequel
Ar₁ à Ar₄ sont chacun indépendamment un phényle, un biphénylyle ou un terphénylyle.

8. Dispositif électroluminescent organique selon la revendication 1, dans lequel
R₁ et R₂ sont chacun indépendamment un méthyle, un phényle, un naphtyle, un benzofuranyle, un phénanthrényle, un naphtylphényle ou un benzofuranylphényle.

9. Dispositif électroluminescent organique selon la revendication 1, dans lequel
le composé représenté par la formule chimique 2 est l'un quelconque choisi dans le groupe constitué des suivants :

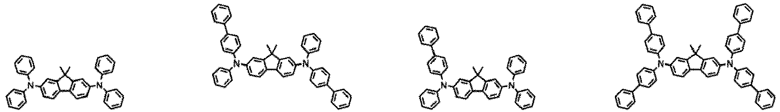

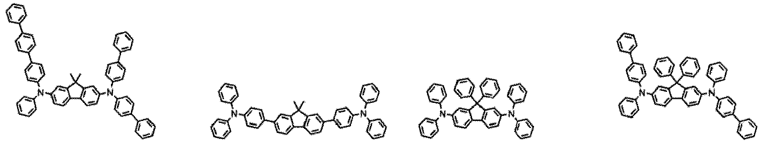

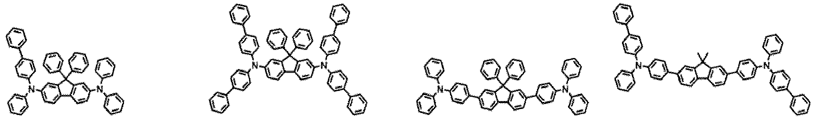

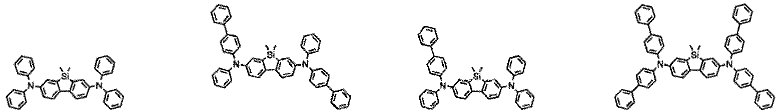

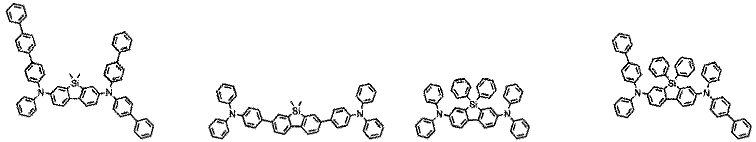

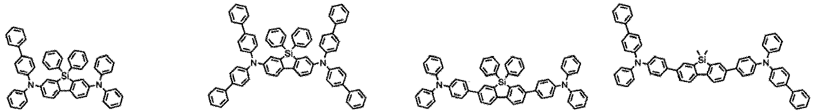

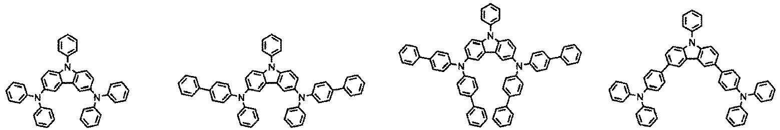

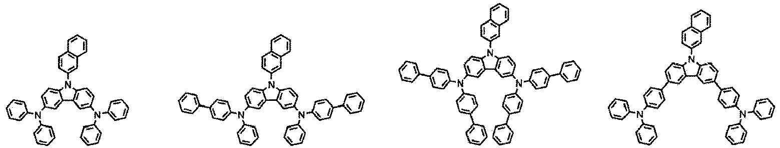

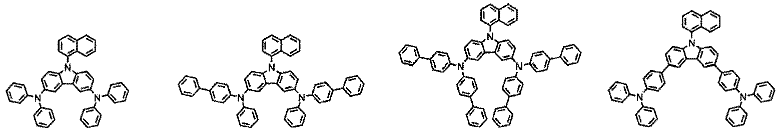

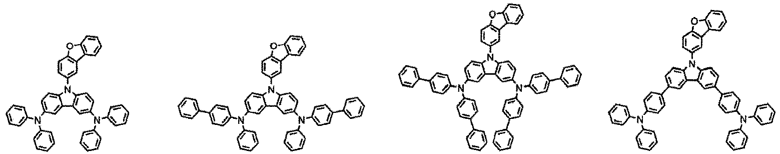

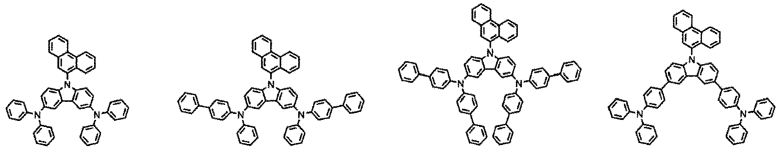

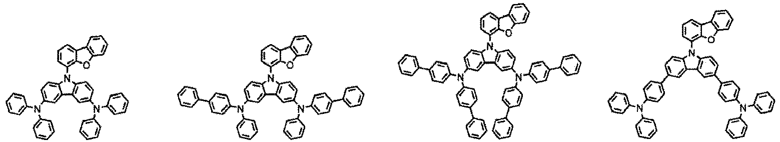

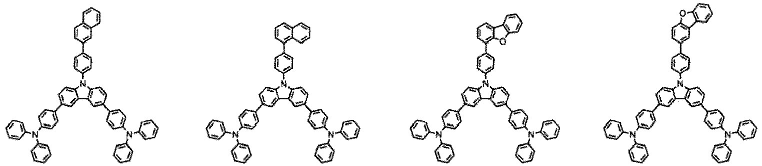

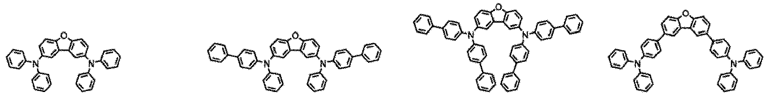

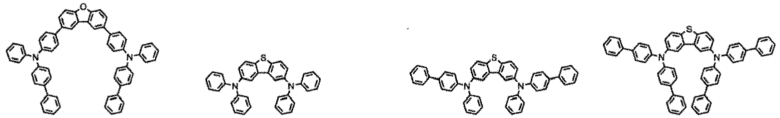

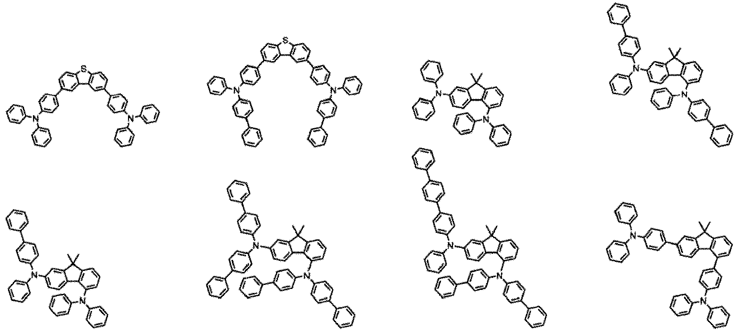

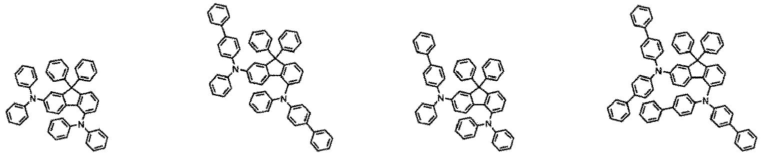

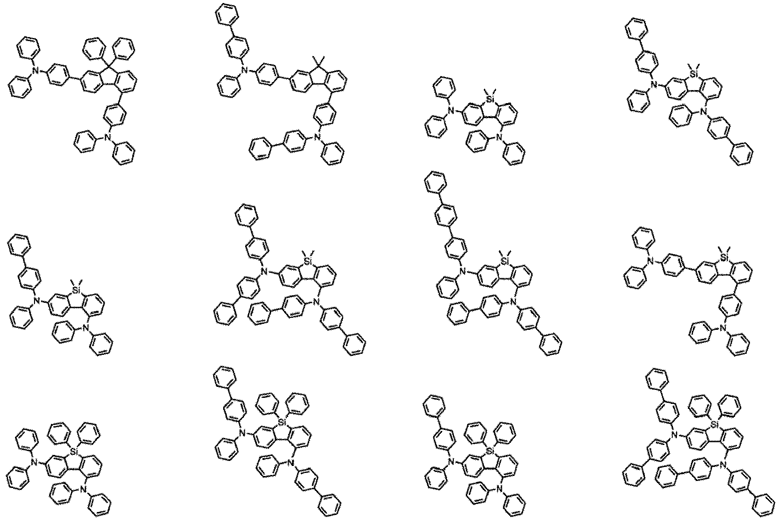

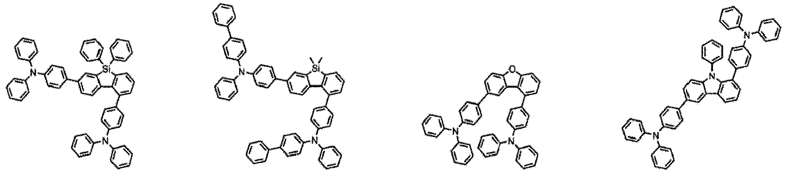

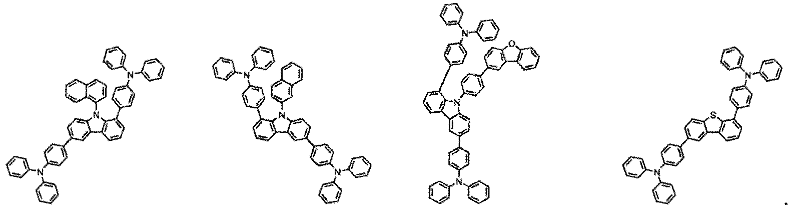

10. Dispositif électroluminescent organique selon la revendication 1, dans lequel
la région de transport de trous (3) comprend une couche de transport de trous (6), et
la couche de transport de trous (6) comprend le composé représenté par la formule chimique 2.

11. Dispositif électroluminescent organique selon la revendication 1, dans lequel
la région de transport de trous (3) comprend une couche de transport de trous (6) et une couche de blocage d'électrons (7), et
la couche de blocage d'électrons (7) comprend le composé représenté par la formule chimique 2.

12. Dispositif électroluminescent organique selon la revendication 11, dans lequel
la couche électroluminescente (4) et la couche de blocage d'électrons (7) sont positionnées de manière adjacente l'une à l'autre.
